(19) Europäisches Patentamt
European Patent Office
Office européen des brevets

(11) **EP 3 435 385 B1**

(12) # EUROPEAN PATENT SPECIFICATION

(45) Date of publication and mention
of the grant of the patent:
**24.08.2022 Bulletin 2022/34**

(21) Application number: **17770249.5**

(22) Date of filing: **22.03.2017**

(51) International Patent Classification (IPC):
*H01B 5/14* (2006.01)   *B32B 7/02* (2019.01)
*B32B 15/01* (2006.01)   *C01G 23/00* (2006.01)
*C04B 35/453* (2006.01)   *C23C 14/06* (2006.01)
*C23C 14/08* (2006.01)   *C23C 14/14* (2006.01)
*H01B 13/00* (2006.01)   *C23C 28/00* (2006.01)
*G06F 3/044* (2006.01)   *C01G 9/02* (2006.01)
*C01G 15/00* (2006.01)   *C03C 17/36* (2006.01)
*C23C 14/58* (2006.01)   *C04B 37/00* (2006.01)
*C04B 37/02* (2006.01)   *C23C 14/18* (2006.01)

(52) Cooperative Patent Classification (CPC):
**B32B 15/01; C01G 9/02; C01G 15/00;
C01G 15/006; C01G 23/00; C01G 23/002;
C03C 17/36; C03C 17/3644; C03C 17/3647;
C03C 17/3655; C03C 17/3671; C04B 35/453;
C04B 37/006; C04B 37/021; C23C 14/08;** (Cont.)

(86) International application number:
**PCT/JP2017/011343**

(87) International publication number:
**WO 2017/164209 (28.09.2017 Gazette 2017/39)**

(54) **LAMINATED TRANSPARENT CONDUCTIVE FILM, LAMINATED WIRING FILM, AND METHOD FOR PRODUCING LAMINATED WIRING FILM**

LAMINIERTE TRANSPARENTE LEITFÄHIGE FOLIE, LAMINIERTE VERDRAHTUNGSFOLIE UND VERFAHREN ZUR HERSTELLUNG EINER LAMINIERTEN VERDRAHTUNGSFOLIE

FILM CONDUCTEUR TRANSPARENT STRATIFIÉ, FILM DE CÂBLAGE STRATIFIÉ, ET PROCÉDÉ DE FABRICATION D'UN FILM DE CÂBLAGE STRATIFIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.03.2016 JP 2016058937
13.02.2017 JP 2017024386**

(43) Date of publication of application:
**30.01.2019 Bulletin 2019/05**

(73) Proprietor: **Mitsubishi Materials Corporation
Chiyoda-ku
Tokyo 100-8117 (JP)**

(72) Inventors:
• **NAKAZAWA, Hiromi**
**Naka-shi**
**Ibaraki 311-0102 (JP)**
• **ISHII, Hiroshi**
**Naka-shi**
**Ibaraki 311-0102 (JP)**
• **TOSHIMORI, Yuto**
**Sanda-shi**
**Hyogo 669-1339 (JP)**
• **SAITO, Atsushi**
**Sanda-shi**
**Hyogo 669-1339 (JP)**
• **HAYASHI, Yujiro**
**Sanda-shi**
**Hyogo 669-1339 (JP)**

(74) Representative: **Hoffmann Eitle**
**Patent- und Rechtsanwälte PartmbB**
**Arabellastraße 30**
**81925 München (DE)**

(56) References cited:
**WO-A1-2011/122497**     **WO-A1-2011/126074**
**WO-A1-2014/097963**     **WO-A1-2016/024615**
**WO-A1-2016/024615**     **WO-A1-2016/111202**
**JP-A- 2004 156 070**     **JP-A- 2007 250 430**
**JP-A- 2009 298 649**     **JP-A- 2009 298 649**
**JP-A- 2012 054 006**     **JP-A- 2012 054 006**
**US-A1- 2008 309 635**     **US-A1- 2014 352 751**

(52) Cooperative Patent Classification (CPC): (Cont.)
**C23C 14/185; C23C 14/5873; C23C 28/321;**
**C23C 28/322; C23C 28/345; C23C 28/3455;**
B32B 15/018; C01P 2002/54; C01P 2002/84;
C01P 2006/40; C03C 2217/944; C03C 2217/948;
C04B 2235/3232; C04B 2235/3286;
C04B 2235/9653; C04B 2237/125; C04B 2237/408;
C04B 2237/706

**Description**

TECHNICAL FIELD

The present invention relates to a multilayer transparent conductive film that can be used as a transparent electrode film in a display, a touch panel, or the like, a multilayer wiring film formed of the multilayer transparent conductive film, and a method of forming the multilayer wiring film.

BACKGROUND ART

As a transparent electrode film in a liquid crystal display, an organic EL display, a touch panel, or the like, for example, a transparent conductive film disclosed in Patent Documents 1 to 4 is provided. This transparent conductive film is required to have high transmittance of light in a visible range and low electrical resistance.

Here, in Patent Document 1, an ITO film that is formed of ITO ($In_2O_3$+Sn) as a transparent conductive oxide is used as a transparent conductive film. In order to reduce the electrical resistance of the ITO film, it is necessary to form the ITO film to be thick, and thus the transmittance in a visible range decreases. Accordingly, it is difficult to realize high transmittance and low electrical resistance at the same time.

In addition, in Patent Document 2, a metal mesh material formed of Cu or the like is used. However, in order to reduce the electrical resistance of the metal mesh material, it is necessary to widen the width of a metal portion, and thus there is also a problem in that the transmittance decreases. In addition, since the metal mesh material may be recognized by light reflection, it is necessary to form a blackening film or the like on a surface of the metal mesh material.

Patent Documents 3 and 4 disclose a multilayer transparent conductive film in which an Ag film and a transparent conductive oxide film are laminated. In the multilayer transparent conductive film, conductivity is secured by the Ag film. Therefore, it is not necessary that a thick transparent conductive oxide film be formed to reduce electrical resistance, and thus a relatively high transmittance can be obtained.

Patent Document 5 describes a multilayer structure including a metal layer including Ag and a transparent conductive film, wherein the transparent conductive film includes ZnO, Ti and one or more selected from the group consisting of Ga and Al.

Citation List

Patent Document

[Patent Document 1] Japanese Unexamined Patent Application, First Publication No. 2008-310550
[Patent Document 2] Japanese Unexamined Patent Application, First Publication No. 2006-344163
[Patent Document 3] Japanese Unexamined Patent Application, First Publication No. S63-110507
[Patent Document 4] Japanese Unexamined Patent Application, First Publication No. H09-232278
[Patent Document 5] JP 2009 298649 A

DISCLOSURE OF INVENTION

Technical Problem

However, recently, in a display, a touch panel, or the like, the sizes of a wiring and a transparent electrode have been reduced. Further, the lengths of a wiring and a transparent electrode have been increased along with an increase in the size of a screen. As a transparent electrode, a transparent conductive film having a lower electrical resistance and a higher transmittance in a visible range than those of the related art is required.

Here, in the multilayer transparent conductive film disclosed in Patent Documents 3 and 4, it is necessary that the thickness of the Ag film be reduced in order to further reduce electrical resistance and to further improve transmittance. However, in a case where the thickness of the Ag film is simply reduced, Ag is likely to aggregate, surface plasmon absorption occurs due to the aggregation of Ag, and there is a problem in that the transmittance significantly decreases. In addition, since the Ag film is formed as a discontinuous film due to the aggregation of Ag, there is a problem in that electrical resistance increases and conductivity deteriorates.

In addition, in a case where barrier properties of a transparent conductive oxide film against moisture are low, moisture reaches up to the Ag film in a high-humidity environment, the aggregation of Ag in the Ag film is promoted, and transmittance and conductivity may deteriorate.

Further, in order to use the multilayer transparent conductive film as a wiring film, it is necessary to form a wiring pattern on the multilayer transparent conductive film. In this case, a resist film is formed on the multilayer transparent conductive film, a wiring pattern is formed by etching, and then the resist film is removed. In a case where the wiring pattern is formed by etching, it is desirable to collectively etch the entire region of the multilayer transparent conductive film using an etchant. However, in a case where an electrode pattern is formed by etching on a multilayer film including an Ag alloy film and an ITO film, the etching rate of the Ag alloy film is higher than that of the ITO film. Therefore, in a case where the Ag alloy film and the ITO film are collectively etched using the same etchant, the Ag alloy film may be significantly over-etched, or ITO film residues may remain. In addition, in a case where a resist film is removed, an alkaline resist remover is used. However, a multilayer transparent conductive film of the related art has insufficient alkali resistance, and in a case where a resist film is removed, there is a problem in that characteristics of the multilayer transparent conductive film deteriorate.

The present invention has been made in consideration of the above-described circumstances, and an object thereof is to provide: a multilayer transparent conductive film in which transmittance is sufficiently high, electrical resistance is sufficiently low, environment resistance and alkali resistance are high, and over-etching is not likely to occur during formation of a wiring pattern using an etching method; a multilayer wiring film formed of the multilayer transparent conductive film; and a method of forming the multilayer wiring film.

Solution to Problem

According to the present invention for solving the above-described problems, a multilayer transparent conductive film is provided, including: an Ag film that is formed of Ag or an Ag alloy, the Ag alloy optionally including 0.2 at% to 10.0 at% of one element or two or more elements in total selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er and a balance of Ag and inevitable impurities; and a transparent conductive oxide film that is disposed on two opposite surfaces of the Ag film, in which the transparent conductive oxide film is formed of an oxide including Zn, Ga, Ti, and optionally Y, characterized in that atomic proportions with respect to all the metal elements included in the transparent conductive oxide film (11, 13) are Ga: 1.0 at% to 30.0 at%, Ti: 0.1 at% to 10.0 at%, optionally Y: 0.1 at% to 10.0 at%, and a balance of Zn.

In the multilayer transparent conductive film according to the present invention, the transparent conductive oxide film formed of the oxide including Zn, Ga, and Ti is formed on two opposite surfaces of the Ag film. Therefore, wettability of the Ag film is improved by the lower transparent conductive oxide film, and aggregation of Ag in the Ag film can be prevented even in a case where the Ag film is formed to be thin. In addition, the transparent conductive oxide film has high environment resistance (durability in a high-temperature and high-humidity environment). Therefore, even in a case where the multilayer transparent conductive film is used in a high-humidity environment, penetration of moisture into the Ag film can be prevented due to the transparent conductive oxide film formed above the Ag film, and aggregation of Ag can be prevented. Accordingly, a multilayer transparent conductive film having a sufficiently high transmittance and a sufficiently low electrical resistance can be provided.

Further, in a case where an acidic mixed solution including phosphoric acid and acetic acid is used as an etchant, a difference in etching rate between the Ag film and the transparent conductive oxide film is small. Therefore, even in a case where the multilayer transparent conductive film is collectively etched, a wiring pattern can be accurately formed.

In addition, the alkali resistance of the transparent conductive oxide film is high. Therefore, in a case where the resist film is removed using the alkaline resist remover to form a wiring pattern, deterioration of characteristics of the multilayer transparent conductive film can be prevented.

In the multilayer transparent conductive film according to the present invention, atomic proportions with respect to all the metal elements included in the transparent conductive oxide film be Ga: 1.0 at% to 30.0 at%, Ti: 0.1 at% to 10.0 at%, optionally Y: 0.1 at% to 10.0 at%, and a balance of Zn.

In this case, the Ga content with respect to all the metal elements included in the transparent conductive oxide film is in a range of 1.0 at% to 30 at%. Therefore, aggregation of the Ag film can be prevented, and an increase in electrical resistance can be prevented. In addition, the Ti content is in a range of 0.1 at% to 10.0 at%. Therefore, alkali resistance and environment resistance can be improved while preventing an increase in electrical resistance.

Further, in the multilayer transparent conductive film according to the present invention, it is more preferable that atomic proportions with respect to all the metal elements included in the transparent conductive oxide film be Ga: 1.0 at% to 18.0 at%, Ti: 0.1 at% to 10.0 at%, and a balance of Zn.

In this case, the Ga content with respect to all the metal elements included in the transparent conductive oxide film is in a range of 1.0 at% to 18.0 at%. Therefore, aggregation of the Ag film can be further prevented, and an increase in electrical resistance can be further prevented. In addition, the Ti content is in a range of 0.1 at% to 10.0 at%. Therefore, alkali resistance and environment resistance can be improved while preventing an increase in electrical resistance.

Further, in the multilayer transparent conductive film according to the present invention, it is more preferable that atomic proportions with respect to all the metal elements included in the transparent conductive oxide film be Ga: 1.0 at% to 14.0 at%, Ti: 0.1 at% to 10.0 at%, and a balance of Zn.

In this case, the Ga content with respect to all the metal elements included in the transparent conductive oxide film is in a range of 1.0 at% to 14.0 at%. Therefore, aggregation of the Ag film can be further prevented, and an increase in electrical resistance can be further prevented. In addition, the Ti content is in a range of 0.1 at% to 10.0 at%. Therefore, alkali resistance and environment resistance can be improved while preventing an increase in electrical resistance.

In addition, in the multilayer transparent conductive film according to the present invention, the oxide which forms the transparent conductive oxide film may further include Y.

In this case, the oxide which forms the transparent conductive oxide film includes Y. Therefore, alkali resistance and environment resistance can further be improved while preventing an increase in electrical resistance.

In a case where the oxide which forms the transparent conductive oxide film further includes Y, atomic proportions with respect to all the metal elements included in the transparent conductive oxide film be Ga: 1.0 at% to 30.0 at%, Ti: 0.1 at% to 10.0 at%, Y: 0.1 at% to 10.0 at%, and a balance of Zn.

In this case, the Ga content with respect to all the metal elements included in the transparent conductive oxide film is in a range of 1.0 at% to 30 at%. Therefore, aggregation of the Ag film can be prevented, and an increase in electrical resistance can be prevented. In addition, the Ti content is in a range of 0.1 at% to 10.0 at%. Therefore, alkali resistance and environment resistance can be improved while preventing an increase in electrical resistance. Further, the Y content is in a range of 0.1 at% to 10.0 at%. Therefore, alkali resistance can be improved while preventing an increase in electrical resistance.

Further, in the multilayer transparent conductive film according to the present invention, it is preferable that the Ag film be formed of an Ag alloy including 0.2 at% to 10.0 at% of one element or two or more elements in total selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er and a balance of Ag and inevitable impurities.

In this case, the Ag film includes one element or two or more elements in total selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er. Therefore, aggregation of the Ag film can be further prevented, and the Ag film can be formed as a continuous film even in a case where the Ag film has an extremely small thickness of 10 nm or less.

In addition, in the multilayer transparent conductive film according to the present invention, it is preferable that a thickness of the Ag film be 10 nm or less.

In this case, the thickness of the Ag film is 10 nm or less. Therefore, the transmittance can be improved. In addition, the transparent conductive oxide film is formed on two opposite surfaces of the Ag film. Therefore, even in a case where the thickness of the Ag film is 10 nm or less, the Ag film can be formed as a continuous film without aggregation of Ag. Thus, the electrical resistance can be reduced.

In addition, in the multilayer transparent conductive film according to the present invention, it is preferable that an average transmittance in a visible wavelength range of 400 to 800 nm be 85% or higher and a sheet resistance value be 20 $\Omega$/sq. or lower.

In this case, the average transmittance in a visible range of 400 to 800 nm is 85% or higher, and the sheet resistance value is 20 $\Omega$/sq. or lower. Therefore, the multilayer transparent conductive film has sufficiently high transmittance and sufficiently low electrical resistance, and thus can be used as a fine transparent electrode film or a fine transparent wiring film.

According to the present invention, a multilayer wiring film that is formed of the above-described multilayer transparent conductive film is provided, the multilayer wiring film including a wiring pattern.

The multilayer wiring film according to the present invention is formed of the above-described multilayer transparent conductive film, and thus has low electrical resistance and high transmittance.

According to the present invention, a method of forming the multilayer wiring film is provided, the method including: a multilayer transparent conductive film forming step of forming the multilayer transparent conductive film including the Ag film and the transparent conductive oxide film on a film forming surface of a base material; a resist film forming step of forming a resist film having a wiring pattern shape on the multilayer transparent conductive film; an etching step of collectively etching the multilayer transparent conductive film on which the resist film is formed by using an acidic mixed solution including phosphoric acid and acetic acid as an etchant; and a resist film removing step of removing the resist film using the alkaline resist remover or the like after etching.

In the method of forming the multilayer wiring film having the above-described configuration, in a case where the acidic mixed solution including phosphoric acid and acetic acid is used as an etchant, a difference in etching rate between the Ag film and the transparent conductive oxide film is small. Therefore, even in a case where the multilayer transparent conductive film is collectively etched, the over-etching of the Ag film or the remaining of residues of the transparent conductive oxide film can be prevented, and the wiring pattern can be accurately formed. In addition, the alkali resistance of the transparent conductive oxide film is improved due to the addition of Ti or the addition of Ti and Y. Therefore, even in a case where the resist film is removed using the alkaline resist remover in the resist film removing step, deterioration of the characteristics of the multilayer wiring film can be prevented.

In addition, according to the present invention, a method of forming the multilayer wiring film is provided, including: a resist film forming step of forming a resist film having a reverse pattern shape of the wiring pattern on a film forming surface of a base material; a multilayer transparent conductive film forming step of forming the multilayer transparent conductive film including the Ag film and the transparent conductive oxide film on the film forming surface of the base material on which the resist film is formed; and a resist film removing step of removing the resist film.

In the method of forming the multilayer wiring film having the above-described configuration, the resist film is formed on the film forming surface of the base material in a reverse pattern shape of the wiring pattern, and the multilayer transparent conductive film is formed on the film forming surface of the base material on which the resist film is formed. As a result, in a case where the resist film is removed from the base material after the formation of the multilayer transparent conductive film, the multilayer transparent conductive film remains only in a region the resist film is not formed, and the multilayer wiring film including the wiring pattern can be formed. Therefore, it is not necessary to perform the etching step, and the wiring pattern can be accurately formed. In addition, the alkali resistance of the transparent conductive oxide film is improved due to the addition of Ti or the addition of Ti and Y. Therefore, even in a case where the resist film is removed using the alkaline resist remover in the resist film removing step, deterioration of the characteristics of the multilayer wiring film can be prevented.

Advantageous Effects of Invention

According to the present invention, it is possible to provide: a multilayer transparent conductive film in which transmittance is sufficiently high, electrical resistance is sufficiently low, environment resistance and alkali resistance are high, and over-etching is not likely to occur; a multilayer wiring film formed of the multilayer transparent conductive film; and a method of forming the multilayer wiring film.

BRIEF DESCRIPTION OF DRAWINGS

FIG. 1 is a partially enlarged cross-sectional view showing a multilayer transparent conductive film according to an embodiment of the present invention.
FIG. 2 is a partially enlarged cross-sectional view showing a multilayer wiring film according to the embodiment of the present invention.
FIG. 3 is a flowchart showing a method of forming the multilayer wiring film according to the embodiment of the present invention.
FIG. 4 is a diagram showing the method of forming the multilayer wiring film shown in FIG. 3.
FIG. 5 is a flowchart showing a method of forming a multilayer wiring film according to another embodiment of the present invention.
FIG. 6 is a diagram showing the method of forming the multilayer wiring film shown in FIG. 5.
FIG.7 shows surface observation images showing an example of the results after a patterning test using an etching method, in which FIG. 7(a) shows Example 3 and FIG. 7(b) shows Comparative Example 2.
FIG. 8 is a cross-section observation image showing an example of the results after the patterning test using an etching method (Example 3).

BEST MODE FOR CARRYING OUT THE INVENTION

Hereinafter, a multilayer transparent conductive film according to an embodiment of the present invention will be described with reference to the accompanying drawings.

A multilayer transparent conductive film 10 according to the embodiment is used as a transparent electrode film for various displays and touch panels and particularly is used for a capacitive touch panel having a tablet size or more.

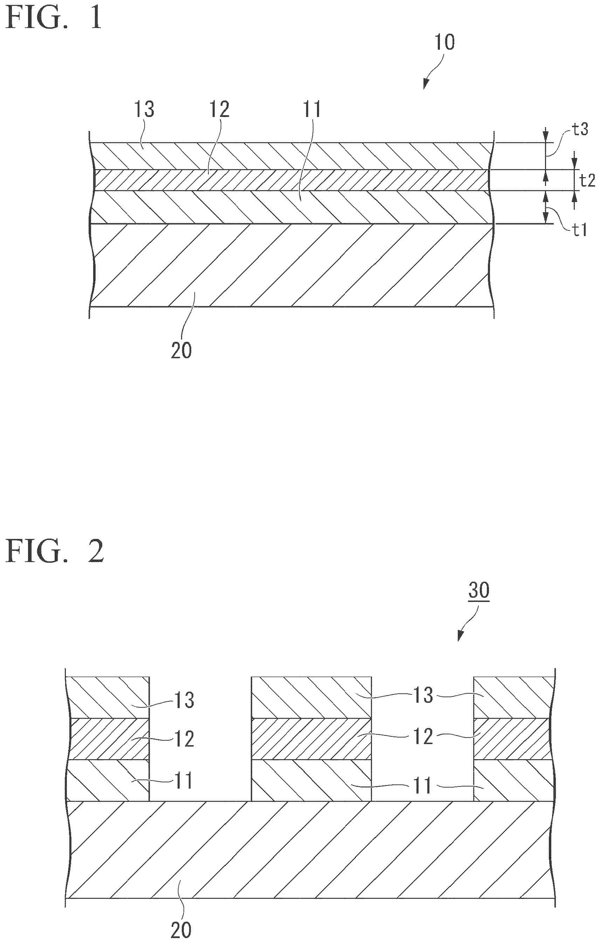

The multilayer transparent conductive film 10 according to the embodiment is shown in FIG. 1. For example, the multilayer transparent conductive film 10 includes: a first transparent conductive oxide film 11 that is formed as an underlayer on one surface of a substrate 20 as a base material; an Ag film 12 that is formed on the first transparent conductive oxide film 11; a second transparent conductive oxide film 13 that is formed on the Ag film 12. As the substrate 20, for example, a glass substrate or a resin film can be used.

In the multilayer transparent conductive film 10 according to the embodiment, an average transmittance in a visible wavelength range of 400 to 800 nm is 85% or higher, and a sheet resistance value is 20 $\Omega$/sq. or lower.

The average transmittance of the multilayer transparent conductive film 10 in a visible wavelength range of 400 to 800 nm is preferably 85% or higher and more preferably 86% or higher. The higher the average transmittance, the better. Therefore, the upper limit value is not particularly limited but is preferably 95% and more preferably 90%. In addition, the sheet resistance value of the multilayer transparent conductive film 10 is preferably 20 Ω/sq. or lower and more preferably 5 Ω/sq. or lower. The lower the sheet resistance value of the multilayer transparent conductive film 10, the better. Therefore, the lower limit value is not particularly limited but is preferably 0.5 Ω/sq. and more preferably 1 Ω/sq.

The Ag film 12 is formed of Ag or an Ag alloy. Ag or the Ag alloy forming the Ag film 12 may be pure Ag having a purity of 99.9 mass% or higher or an Ag alloy including additive elements such as Cu, Sn, Sb, Ti, Mg, Zn, Ge, In, Al, Ga, Pd, Au, Pt, Bi, Mn, Sc, Y, Nd, Sm, Eu, Gd, Tb, and Er.

From the viewpoint of preventing an increase in the absorptance of the Ag film 12 (a decrease in transmittance) and an increase in electrical resistance, the content of the additive elements is preferably 10.0 at% or lower and more preferably 2.0 at% or lower.

In the embodiment, the Ag film 12 is formed of an Ag alloy including 0.2 at% to 10.0 at% of one element or two or more elements in total selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er and a balance of Ag and inevitable impurities.

In the embodiment, Cu, Sn, Sb, Ti, Mg, Zn, Ge, In, Al, Ga, Pd, Au, Pt, Bi, Mn, Sc, Y, Nd, Sm, Eu, Gd, Tb, and Er included in the Ag alloy forming the Ag film 12 are elements that have an effect of improving wettability of the Ag film 12 on the first transparent conductive oxide film 11, and can prevent aggregation of Ag even in a case where the Ag film 12 is formed to be thin.

Here, in a case where the total content of one element or two or more elements selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er is lower than 0.2 at%, the above-described effect may not be sufficiently exhibited. On the other hand, in a case where the total content of one element or two or more elements selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er is higher than 10.0 at%, the transmittance of the Ag film 12 may decrease and the resistance value may increase.

Due to the above-described reasons, in the embodiment, the total content of one element or two or more elements selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er in the Ag alloy forming the Ag film 12 is in a range of 0.2 at% to 10.0 at%.

In order to reliably exhibit the above-described effect, the lower limit of the total content of one element or two or more elements selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er in the Ag alloy forming the Ag film 12 is preferably 0.3 at% or higher and more preferably 0.5 at% or higher. On the other hand, in order to prevent a decrease in transmittance and an increase in resistivity, the upper limit of the total content of one element or two or more elements selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er is preferably 8.0 at% or lower, more preferably 5.0 at% or lower, and still more preferably 2.0 at% or lower.

In the embodiment, the first transparent conductive oxide film 11 and the second transparent conductive oxide film 13 are formed of an oxide including Zn, Ga, and Ti or an oxide including Zn, Ga, Ti, and Y

That is, the first transparent conductive oxide film 11 and the second transparent conductive oxide film 13 are formed of a Zn oxide to which Ga and Ti are added or Ga, Ti, and Y are added.

In the embodiment, atomic proportions of Ga, Ti, and Y with respect to all the metal elements included in each of the first transparent conductive oxide film 11 and the second transparent conductive oxide film 13 are Ga: 1.0 at% to 30.0 at%, Ti: 0.1 at% to 10.0 at%, and Y: 0.1 at% to 10.0 at%.

The first transparent conductive oxide film 11 and the second transparent conductive oxide film 13 do not necessarily have the same composition and only have to be in the above-described composition range.

Here, the Ga content (the atomic proportion of Ga with respect to all the metal elements) with respect to all the metal elements included in each of the first transparent conductive oxide film 11 and the second transparent conductive oxide film 13 is 1.0 at% or higher. As a result, aggregation of Ag in the Ag film 12 can be prevented, and an increase in the electrical resistance of the multilayer transparent conductive film 10 can be prevented. On the other hand, by adjusting the Ga content to be 30.0 at% or lower, an increase in the electrical resistance of the first transparent conductive oxide film 11 and the second transparent conductive oxide film 13 can be prevented. Further, by adjusting the Ga content to be 18.0 at% or lower, an increase in the electrical resistance of the first transparent conductive oxide film 11 and the second transparent conductive oxide film 13 can be further prevented.

In order to prevent aggregation of Ag in the Ag film 12, the lower limit of the Ga content is preferably 2.0 at% or higher. In addition, in order to reliably prevent an increase in the electrical resistance of the first transparent conductive oxide film 11 and the second transparent conductive oxide film 13, the upper limit of the Ga content is preferably 25.0 at% or lower, more preferably 20.0 at% or lower, still more preferably 18.0 at% or lower, and even still more preferably 14.0 at% or lower.

In addition, by adjusting the Ti content with respect to all the metal elements included in each of the first transparent conductive oxide film 11 and the second transparent conductive oxide film 13 to be 0.1 at% or higher, alkali resistance and environment resistance of the first transparent conductive oxide film 11 and the second transparent conductive oxide film 13 can be improved. On the other hand, by adjusting the Ti content to be 10.0 at% or lower, an increase in the electrical resistance of the first transparent conductive oxide film 11 and the second transparent conductive oxide film 13 can be prevented.

In order to reliably improve the alkali resistance and environment resistance of the first transparent conductive oxide film 11 and the second transparent conductive oxide film 13, the lower limit of the Ti content is preferably 0.2 at% or higher and more preferably 0.5 at% or higher. In order to reliably prevent an increase in the electrical resistance of the first transparent conductive oxide film 11 and the second transparent conductive oxide film 13, the upper limit of the Ti content is preferably 9.0 at% or lower and more preferably 8.0 at% or lower.

Further, by adjusting the Y content with respect to all the metal elements included in each of the first transparent conductive oxide film 11 and the second transparent conductive oxide film 13 to be 0.1 at% or higher, alkali resistance of the first transparent conductive oxide film 11 and the second transparent conductive oxide film 13 can be improved. On the other hand, by adjusting the Y content to be 10.0 at% or lower, an increase in the electrical resistance of the first transparent conductive oxide film 11 and the second transparent conductive oxide film 13 can be prevented.

In order to reliably improve the alkali resistance of the first transparent conductive oxide film 11 and the second transparent conductive oxide film 13, the lower limit of the Y content is preferably 0.2 at% or higher and more preferably 0.5 at% or higher. In order to reliably prevent an increase in the electrical resistance of the first transparent conductive oxide film 11 and the second transparent conductive oxide film 13, the upper limit of the Y content is preferably 9.0 at% or lower and more preferably 8.0 at% or lower.

In addition, in order to reliably prevent an increase in the electrical resistance of the first transparent conductive oxide film 11 and the second transparent conductive oxide film 13, the total content of Ga, Ti, and Y is preferably 35.0 at% or lower, more preferably 30.0 at% or lower, and still more preferably 25.0 at% or lower.

Here, in the embodiment, in order to improve the transmittance, a thickness t2 of the Ag film 12 is set to be 10 nm or less. In order to further improve the transmittance, the thickness t2 of the Ag film 12 is preferably 9 nm or less and more preferably 8 nm or less. In addition, the lower limit of the thickness t2 of the Ag film 12 is preferably 3 nm or more and more preferably 4 nm or more.

A thickness t1 of the first transparent conductive oxide film 11 and a thickness t3 of the second transparent conductive oxide film 13 are set such that the transmittance in a visible range is improved due to an optical interference effect by performing an optical simulation on a three-layer structure of the first transparent conductive oxide film/Ag film (Ag alloy film)/second transparent conductive oxide film using optical constants (a refractive index and an extinction coefficient) of each of the single layer films.

It is preferable that the thickness t1 (nm) of the first transparent conductive oxide film 11 and the thickness t3 (nm) of the second transparent conductive oxide film 13 be substantially in the following range.

$$t1 = 550/(4 \times n1) \times k1$$

$$t3 = 550/(4 \times n3) \times k3$$

Here, n1 and n3 represent a refractive index (n1) of the first transparent conductive oxide film 11 and a refractive index (n3) of the second transparent conductive oxide film 13, respectively. In addition, k1 and k3 represent a coefficient (k1) of the first transparent conductive oxide film 11 and a coefficient (k3) of the second transparent conductive oxide film 13, respectively. That is, in the optical simulation, the thicknesses are obtained after optimizing the coefficients k1 and k3 to improve the transmittance in a visible range.

Optimum values of the coefficients k1 and k3 vary depending on the transparent conductive oxide, respectively. However, the coefficients k1 and k3 are preferably in a range of 0.2 to 0.8 and more preferably in a range of 0.4 to 0.7. In particular, in a case where the coefficients k1 and k3 are about 0.6, the transmittance in a visible range is improved irrespective of the kind of the transparent conductive oxide.

In the embodiment, as a result of the optical simulation, the thickness t1 of the first transparent conductive oxide film 11 and the thickness t3 of the second transparent conductive oxide film 13 are set as 40 nm. These thicknesses are set assuming that the coefficients k1 and k3 are 0.6.

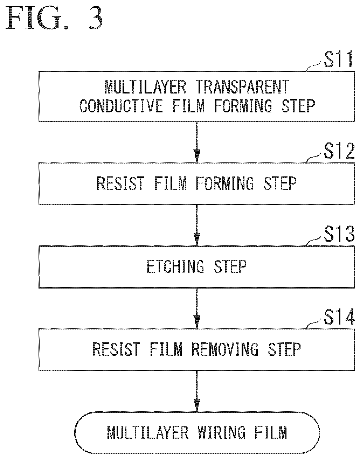

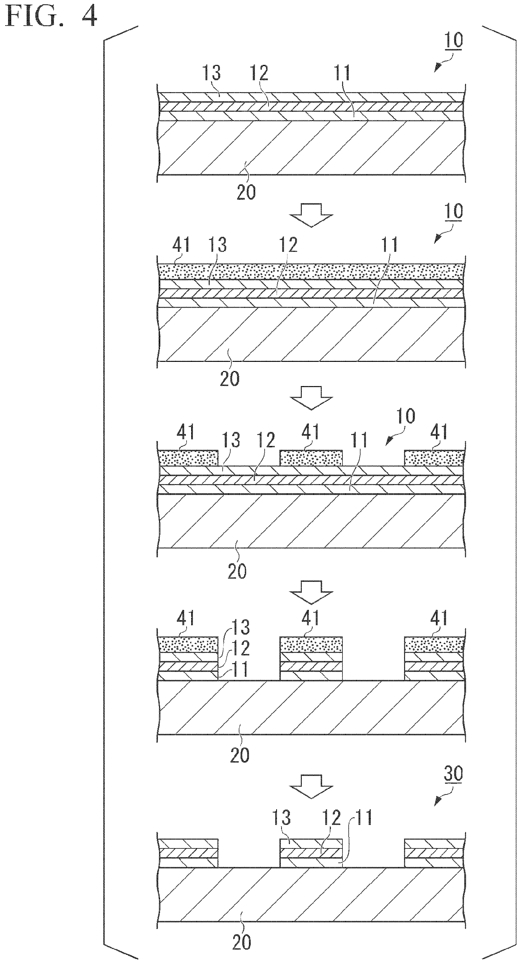

Next, a multilayer wiring film 30 according to the embodiment of the present invention and a method of forming the multilayer wiring film 30 will be described with reference to FIGS. 2 to 4.

In the multilayer wiring film 30 according to the embodiment, as shown in FIG. 2, a wiring pattern is formed on the multilayer transparent conductive film 10 shown in FIG. 1. Here, in the wiring pattern of the multilayer wiring film 30 according to the embodiment, a line width and the width of a space between lines are in a range of 1 $\mu$m to 900 $\mu$m.

Here, the multilayer wiring film 30 is formed as follows.

First, the multilayer transparent conductive film 10 according to the embodiment is formed on a film forming surface of the substrate 20 as a base material (multilayer transparent conductive film forming step S11).

In the multilayer transparent conductive film forming step S11, the first transparent conductive oxide film 11 is formed as an underlayer on the substrate 20. It is preferable that the first transparent conductive oxide film 11 be formed by DC sputtering using a sintered target with which the film composition can be easily controlled. Next, the Ag film 12 is formed on the formed first transparent conductive oxide film 11 by DC sputtering using an Ag target. The Ag target has a composition corresponding to the composition of the formed Ag film 12. The second transparent conductive oxide film 13 is formed on the formed Ag film 12 by DC sputtering using a transparent conductive oxide target. It is preferable that the transparent conductive oxide target be a sintered target with which the film composition can be easily controlled. This way, the multilayer transparent conductive film 10 according to the embodiment is formed.

Next, a resist film 41 is formed on the multilayer transparent conductive film 10 formed on the surface of the substrate 20, and the resist film 41 is exposed and developed. As a result, a wiring pattern is formed (resist film forming step S12).

Next, the multilayer transparent conductive film 10 on which the resist film 41 is formed is collectively etched by using an acidic mixed solution including phosphoric acid and acetic acid as an etchant (etching step S13). Here, in the acidic mixed solution including phosphoric acid and acetic acid, it is preferable that the content of the phosphoric acid be 55 vol% or higher and the content of the acetic acid be 30 vol% or higher. The mixed solution may include 20 vol% or lower of nitric acid in addition to phosphoric acid and acetic acid.

Next, the resist film 41 is removed using an alkaline resist remover (resist film removing step S14).

As a result, the multilayer transparent conductive film 10 positioned below the resist film 41 having a wiring pattern shape remains, and the multilayer wiring film 30 including the wiring pattern is formed.

In the multilayer transparent conductive film 10 according to the embodiment having the above-described configuration, the first transparent conductive oxide film 11 is formed as an underlayer on the surface of the substrate 20, and the Ag film 12 is formed on the first transparent conductive oxide film 11. Therefore, wettability of the Ag film 12 is improved, and aggregation of Ag is prevented even in a case where the Ag film 12 is formed to be thin.

Further, the first transparent conductive oxide film 11 and the second transparent conductive oxide film 13 have high environment resistance. Therefore, even in a case where the multilayer transparent conductive film 10 is used in a high-humidity environment, penetration of moisture into the Ag film 12 can be prevented, and aggregation of Ag can be prevented.

Accordingly, the occurrence of surface plasmon absorption caused by aggregation of Ag in the Ag film 12 can be prevented, and high transmittance can be obtained. In addition, the Ag film 12 is formed as a continuous film, and thus electrical resistance can also be reduced.

In the embodiment, the first transparent conductive oxide film 11 and the second transparent conductive oxide film 13 are formed of a Zn oxide to which Ga and Ti are added or Ga, Ti, and Y are added, and atomic proportions of Ga, Ti, and Y with respect to all the metal elements included in each of the transparent conductive oxide films are Ga: 1.0 at% to 30.0 at%, Ti: 0.1 at% to 10.0 at%, and Y: 0.1 at% to 10.0 at%. Therefore, aggregation of Ag can be prevented due to addition of Ga, and an increase in electrical resistance can be prevented. In addition, alkali resistance and environment resistance can be improved due to the addition of Ti. Further, alkali resistance can be improved due to the addition of Y

Further, in the embodiment, the thickness t2 of the Ag film 12 is set to be 10 nm or less. Therefore, the transmittance can be improved. In addition, the first transparent conductive oxide film 11 is formed as an underlayer on the surface of the substrate 20. Therefore, even in a case where the thickness of the Ag film 12 is 10 nm or less, aggregation of Ag does not occur, the Ag film 12 is formed as a continuous film, and electrical resistance can be reduced.

In addition, in the embodiment, the Ag film 12 is formed of an Ag alloy including 0.2 at% to 10.0 at% of one element or two or more elements in total selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er and a balance of Ag and inevitable impurities. Therefore, aggregation of the Ag film 12 can be further prevented, and even in a case where the Ag film 12 is formed to be thinner, the Ag film 12 is formed as a continuous film, and high transmittance and low resistance value can be realized at the same time.

Further, in the multilayer transparent conductive film 10 according to the embodiment, the average transmittance in a visible wavelength range of 400 to 800 nm is 85% or higher, and the sheet resistance value is 20 $\Omega$/sq. or lower. Therefore, the multilayer transparent conductive film 10 has sufficiently high transmittance and sufficiently low electrical resistance, and thus can be used as a fine transparent electrode film or a fine transparent wiring film.

In addition, in the multilayer wiring film 30 according to the embodiment, the wiring pattern is formed on the multilayer transparent conductive film 10 according to the embodiment. Therefore, low electrical resistance and high transmittance can be obtained.

Further, in the embodiment, in a case where the acidic mixed solution including phosphoric acid and acetic acid is used as an etchant in the etching step S13, a difference in etching rate between the Ag film 12, the first transparent conductive oxide film 11, and the second transparent conductive oxide film 13 is small. Therefore, even in a case where the multilayer transparent conductive film 10 is collectively etched, the over-etching of the Ag film 12 or the remaining of residues of the first transparent conductive oxide film 11 and the second transparent conductive oxide film 13 can be prevented, and the wiring pattern can be accurately formed.

In addition, in the embodiment, the alkali resistance of the first transparent conductive oxide film 11 and the second transparent conductive oxide film 13 is improved due to the addition of Ti or the addition of Ti and Y. Therefore, even in a case where the resist film is removed using the alkaline resist remover in the resist film removing step S14, deterioration of the characteristics of the multilayer wiring film 30 can be prevented.

Hereinabove, the embodiment of the present invention has been described. However, the present invention is not limited to the embodiment, and various modifications can be made within a range not departing from the technical ideas of the present invention.

For example, in the above description of the embodiment, the Ag film 12 is formed of an Ag alloy including 0.2 at% to 10.0 at% of one element or two or more elements in total selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er and a balance of Ag and inevitable impurities. However, the Ag film 12 is not limited to this configuration, and may be formed of pure Ag or an Ag alloy including another metal element that is solidsoluble in Ag.

In addition, in the above description of the embodiment, the thicknesses of the first transparent conductive oxide film 11 and the second transparent conductive oxide film 13 are about 40 nm. However, the thicknesses are not limited to this configuration and may be other values. However, as described above in the embodiment, it is preferable that the thicknesses be selected such that the transmittance is improved due to an optical interference effect by performing the optical simulation.

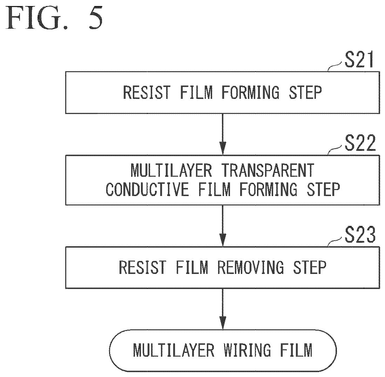

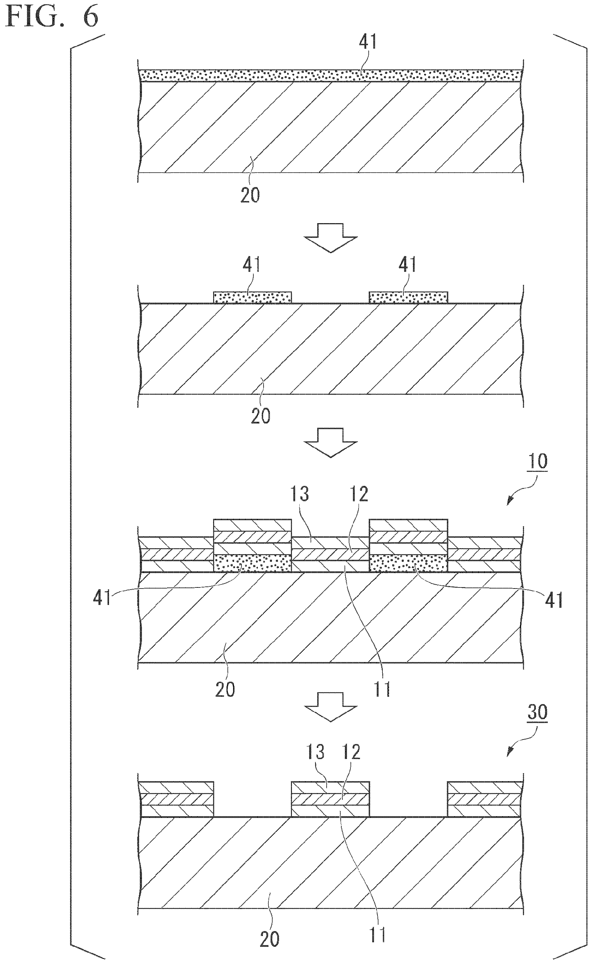

Further, in the above description of the embodiment, the multilayer wiring film 30 is formed using an etching method. However, the embodiment is not limited to this configuration, and the multilayer wiring film 30 may be formed using a lift-off method as shown in FIGS. 5 and 6.

In the method of forming the multilayer wiring film 30 shown in FIGS. 5 and 6, first, the resist film 41 is formed on the film forming surface of the substrate 20, and the resist film 41 is exposed and developed. As a result, a reverse pattern having a reverse shape of the wiring pattern is formed (resist film forming step S21).

Next, the first transparent conductive oxide film 11, the Ag film 12, and the second transparent conductive oxide film 13 are sequentially formed using a sputtering method on the substrate 20 on which the resist film 41 including the reverse pattern is formed. As a result, the multilayer transparent conductive film 10 is formed on the resist film 41 and the substrate 20 (the multilayer transparent conductive film forming step S22).

Next, the resist film 41 is removed using an alkaline resist remover (resist film removing step S23).

As a result, the multilayer transparent conductive film 10 formed on the resist film 41 having the reverse pattern shape is removed, and the multilayer wiring film 30 including the wiring pattern is formed.

According to the method of forming the multilayer wiring film 30 having the above-described configuration, the wiring pattern can be accurately formed without performing the etching step. In addition, the alkali resistance of the first transparent conductive oxide film 11 and the second transparent conductive oxide film 13 is improved due to the addition of Ti or the addition of Ti and Y. Therefore, even in a case where the resist film is removed using alkaline resist remover in the resist film removing step S23, deterioration of the characteristics of the multilayer wiring film 30 can be prevented.

EXAMPLES

The results of an experiment for verifying the effect of the multilayer transparent conductive film according to the present invention will be described.

Each of multilayer transparent conductive films having structures shown in Tables 1, 2, 3, and 4 was formed on a surface of a glass substrate (non-alkali glass: 50 mm×50 mm×1 mmt) using a sputtering method. In Comparative Examples A and B, an ITO single layer film was formed using a sputtering method. In addition, only in Comparative Example B, the glass substrate was heated to 200°C to form a film.

Here, by performing the optical simulation described in the embodiment, the thickness of the transparent conductive oxide film was selected such that the transmittance in a visible range was improved due to an optical interference effect. The thicknesses of all the Examples were 40 nm.

The thicknesses of the Ag film and the transparent conductive oxide films in each of Examples according to the present invention and Comparative Examples were measured using a film thickness meter (DEKTAK, manufactured by ULVAC Inc.).

In addition, the compositions of the transparent conductive oxide films and the Ag alloy film were obtained by performing elemental quantitative analysis using an ICP atomic emission spectrometer (STS-3500DD, manufactured by Hitachi High-Tech Science Corporation).

In order to prepare the transparent conductive oxide films, oxide sintered body targets having compositions shown in Tables 1, 2, 3, and 4 were used.

In order to prepare the Ag films, Ag targets having compositions shown in Tables 1, 2, 3, and 4 were used.

Film forming conditions of each of the films are as follows.

In each of Comparative Examples, the composition of the ITO film (an oxide obtained by adding Sn to $In_2O_3$) was In: 35.6 at%, Sn: 3.6 at%, and O: 60.8 at%.

The composition of the GZO film (an oxide obtained by adding Ga to ZnO) were Zn: 47.3 at%, Ga: 2.2 at%, and O: 50.5 at%.

<Film Forming Conditions of Transparent Conductive Oxide Film>

Sputtering device: a DC magnetron sputtering device (CS-200, manufactured by ULVAC Inc.)
Magnetic field intensity: 1000 Gauss (immediately above the target, vertical component)
Peak vacuum degree: $5 \times 10^{-5}$ Pa or lower
Sputtering gas: mixed gas of $Ar+O_2$ (mixing ratio of $O_2$: 1%)
Sputtering gas pressure: 0.4 Pa
Sputtering power: DC 100 W

<Film Forming Conditions of Ag Film>

Sputtering device: a DC magnetron sputtering device (CS-200, manufactured by ULVAC Inc.)
Magnetic field intensity: 1000 Gauss (immediately above the target, vertical component)
Peak vacuum degree: $5 \times 10^{-5}$ Pa or lower
Sputtering gas: Ar
Sputtering gas pressure: 0.5 Pa
Sputtering power: DC 100 W

Regarding the obtained multilayer transparent conductive film and the ITO single layer film, a sheet resistance and a transmittance after film formation were evaluated.

In addition, a sheet resistance and a transmittance after a temperature-and-humidity-controlled test and a sheet resistance and a transmittance after an alkali resistance test were evaluated.

Further, regarding the obtained multilayer transparent conductive film, a patterning test using an etching method and a patterning test using a lift-off method were performed.

Evaluation methods are as follows.

<Sheet Resistance>

Using a surface resistance meter (Loresta AP MCP-T400, manufactured by Mitsubishi Chemical Corporation), a sheet resistance was measured according to a fourpoint probe method. The results of measuring the sheet resistance are shown in Tables 5, 6, 7, and 8.

<Transmittance>

Using a spectrophotometer (U4100, manufactured by Hitachi High-Technologies Corporation), a transmittance spectrum in a wavelength range of 400 nm to 800 nm was measured to obtain an average transmittance (transmittance). The results of measuring the transmittance are shown in Tables 9, 10, 11, and 12.

<Temperature-And-Humidity-Controlled Test>

After leaving the film to stand in a thermohygrostat bath at a temperature of 85°C and a humidity of 85% for 250 hours, the transmittance and the sheet resistance after the test were measured, and change rates of the transmittance and the sheet resistance from those before the test were evaluated.

<Alkali Resistance Test>

After dipping the film in an alkaline resist remover (pH 9, TOK-104, manufactured by Tokyo Ohka Kogyo Co., Ltd.) at a temperature of 40°C for 10 minutes, the transmittance and the sheet resistance after dipping were measured, and change rates of the transmittance and the sheet resistance from those before dipping were evaluated.

<Patterning Test using Etching Method>

A resist film was formed on the multilayer transparent conductive film using a photolithography method in a wiring pattern shape (line width/space width: 30 $\mu$m/30 $\mu$m). The multilayer transparent conductive film was collectively etched using a mixed solution (SEA-5, manufactured by Kanto Kagaku) including phosphoric acid and acetic acid as an etchant. Etching was performed for an appropriate etching time (20 seconds to 120 seconds) without heating. In addition, in the mixed solution, the content of the phosphoric acid was 55 vol% or lower, and the content of the acetic acid was 30 vol%.

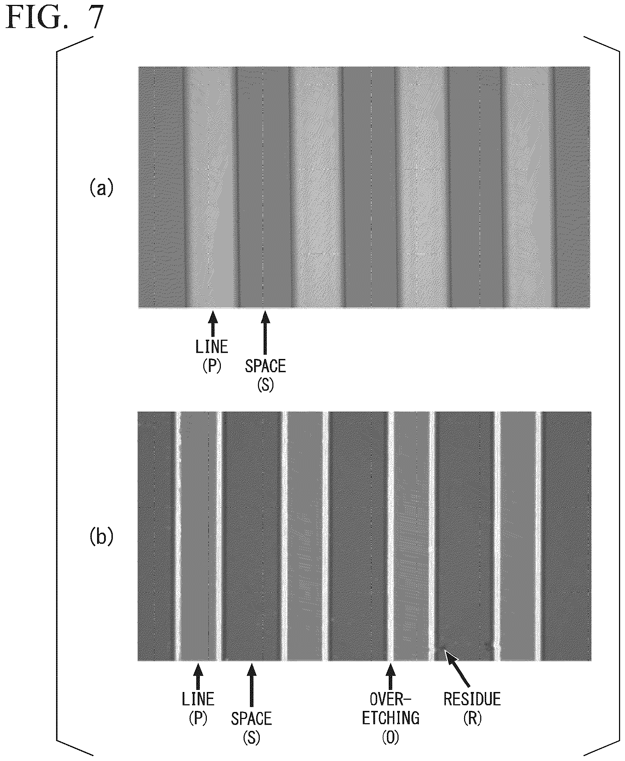

Next, the resist film was removed using an alkaline resist remover (pH9, TOK-104, manufactured by Tokyo Ohka Kogyo Co., Ltd.) to form a wiring pattern, and the formed wiring pattern was observed using an optical microscope (laser microscope VK-X200, manufactured by Keyence Corporation) at a magnification of 50 times to determine whether or not residues of the transparent conductive oxide film were present. Specifically, in a case where the presence of the transparent conductive oxide film remaining in a needle shape or a particle shape without being etched was recognized, it was determined the residues of the transparent conductive oxide film were present. Otherwise, it was determined that the residues of the transparent conductive oxide film were not present. The results of measuring Example 3 and Comparative Example 2 are shown in FIGS. 7(a) and 7(b), respectively. In FIGS. 7(a) and 7(b), a line is represented by the symbol P, a space is represented by the symbol S, over-etching is represented by the symbol O, and a residue is represented by the symbol R.

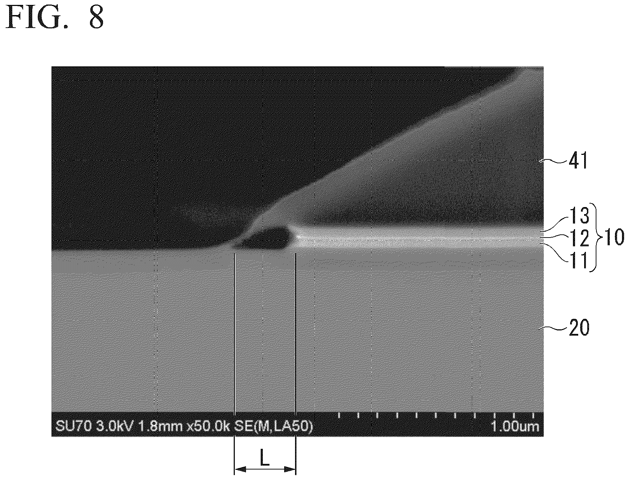

In addition, a cross-section (a cross-section perpendicular to the film forming surface of the substrate 20 perpendicular to the line and the space) of the pattern before removing the resist film was observed using a scanning electron microscope (SU8000, manufactured by Hitachi High-Technologies Corporation) at a magnification of 50000 times. The result of observing the cross-sectional shape of Example 3 is shown in FIG. 8. The length of a portion that was etched up to the inside of the resist film 41 was set as the length of over-etching, and a length L (length in a direction parallel to the film forming surface of the substrate 20) from an end portion of the resist film 41 to an inner end portion of the multilayer transparent conductive film 10 was measured from an observed image thereof. In order to measure the length L, a boundary portion (edge portion) between the substrate 20 and a resist pattern in which the multilayer transparent conductive film 10 was desired to remain was set as the end portion of the resist film 41. In addition, in the inner end portion of the multilayer transparent conductive film 10 remaining between the resist pattern and the substrate 20, a point most distant from the end portion of the resist film 41 in the direction parallel to the film forming surface of the substrate 20 was set as the end portion of the multilayer transparent conductive film 10. The lengths of over-etching of respective samples of Examples and Comparative Examples are shown in Tables 5, 6, 7, and 8. Each of the lengths of over-etching in Tables 5, 6, 7, and 8 are a value of the length L obtained by observing one cross-section.

In addition, the resist was removed, and the surface of the multilayer film was observed by visual inspection.

<Patterning Test using Lift-Off Method>

In addition, a resist solution was applied to the substrate, a photomask on which a wiring pattern (line width/space width: 30 $\mu$m/30 $\mu$m) was formed was attached thereto, and the substrate was exposed to ultraviolet light using an exposure machine. Next, the exposed portion was removed using a developer, and a reverse pattern was formed using a photolithography method.

Next, the multilayer transparent conductive film was formed using the sputtering device as described above on the substrate on which the reverse pattern was formed.

Next, the substrate was dipped in a resist remover (ph9, TOK-104, manufactured by Tokyo Ohka Kogyo Co., Ltd.) to remove the multilayer transparent conductive film formed on the resist film, and then the formed wiring pattern was observed using an optical microscope (laser microscope VK-X200, manufactured by Keyence Corporation) at a magnification of 50 times to measure the accuracy of the electrode pattern. In a case where film peeling or resist residues were observed in the line (P), it was determined that the electrode pattern was not accurately formed. Otherwise, it was determined that the electrode pattern was accurately formed.

[Table 1]

| | | First Transparent Conductive Oxide Film | | | | Ag Film | | Second Transparent Conductive Oxide Film | | | |
|---|---|---|---|---|---|---|---|---|---|---|---|
| | | at% with respect to All Metal Components | | | | Composition | Thickness nm | at% with respect to All Metal Components | | | |
| | | Zn | Ga | Ti | Y | | | Zn | Ga | Ti | Y |
| Example | 1 | Balance | 14.0 | 2.5 | 0.0 | Ag-0.2at%Cu | 10 | Balance | 14.0 | 2.5 | 0.0 |
| | 2 | Balance | 14.0 | 2.5 | 0.0 | Ag-1.0at%Cu | 5 | Balance | 14.0 | 2.5 | 0.0 |
| | 3 | Balance | 14.0 | 2.5 | 0.0 | Ag-1.0at%Cu | 10 | Balance | 14.0 | 2.5 | 0.0 |
| | 4 | Balance | 14.0 | 2.5 | 0.0 | Ag-10.0at%Cu | 5 | Balance | 14.0 | 2.5 | 0.0 |
| | 5 | Balance | 14.0 | 2.5 | 0.0 | Ag-0.2at%Sn | 10 | Balance | 14.0 | 2.5 | 0.0 |
| | 6 | Balance | 14.0 | 2.5 | 0.0 | Ag-1.0at%Sn | 5 | Balance | 14.0 | 2.5 | 0.0 |
| | 7 | Balance | 14.0 | 2.5 | 0.0 | Ag-1.0at%Sn | 10 | Balance | 14.0 | 2.5 | 0.0 |
| | 8 | Balance | 14.0 | 2.5 | 0.0 | Ag-10.0at%Sn | 5 | Balance | 14.0 | 2.5 | 0.0 |
| | 9 | Balance | 14.0 | 2.5 | 0.0 | Ag-0.2at%Sb | 10 | Balance | 14.0 | 2.5 | 0.0 |
| | 10 | Balance | 14.0 | 2.5 | 0.0 | Ag-1.0at%Sb | 5 | Balance | 14.0 | 2.5 | 0.0 |
| | 11 | Balance | 14.0 | 2.5 | 0.0 | Ag-1.0at%Sb | 10 | Balance | 14.0 | 2.5 | 0.0 |
| | 12 | Balance | 14.0 | 2.5 | 0.0 | Ag-5.0at%Sb | 5 | Balance | 14.0 | 2.5 | 0.0 |
| | 13 | Balance | 14.0 | 2.5 | 0.0 | Ag-0.2at%Ti | 10 | Balance | 14.0 | 2.5 | 0.0 |
| | 14 | Balance | 14.0 | 2.5 | 0.0 | Ag-1.0at%Ti | 5 | Balance | 14.0 | 2.5 | 0.0 |
| | 15 | Balance | 14.0 | 2.5 | 0.0 | Ag-1.0at%Ti | 10 | Balance | 14.0 | 2.5 | 0.0 |
| | 16 | Balance | 14.0 | 2.5 | 0.0 | Ag-3.0at%Ti | 5 | Balance | 14.0 | 2.5 | 0.0 |
| | 17 | Balance | 14.0 | 2.5 | 0.0 | Ag-0.2at%Mg | 10 | Balance | 14.0 | 2.5 | 0.0 |
| | 18 | Balance | 14.0 | 2.5 | 0.0 | Ag-1.0at%Mg | 5 | Balance | 14.0 | 2.5 | 0.0 |
| | 19 | Balance | 14.0 | 2.5 | 0.0 | Ag-1.0at%Mg | 10 | Balance | 14.0 | 2.5 | 0.0 |
| | 20 | Balance | 14.0 | 2.5 | 0.0 | Ag-10.0at%Mg | 5 | Balance | 14.0 | 2.5 | 0.0 |
| | 21 | Balance | 30.0 | 0.1 | 0.0 | Ag-1.0at%Cu | 10 | Balance | 30.0 | 0.1 | 0.0 |
| | 22 | Balance | 30.0 | 0.1 | 0.0 | Ag-1.0at%Sn | 10 | Balance | 30.0 | 0.1 | 0.0 |
| | 23 | Balance | 30.0 | 0.1 | 0.0 | Ag-1.0at%Sb | 10 | Balance | 30.0 | 0.1 | 0.0 |
| | 24 | Balance | 30.0 | 0.1 | 0.0 | Ag-1.0at%Ti | 10 | Balance | 30.0 | 0.1 | 0.0 |
| | 25 | Balance | 30.0 | 0.1 | 0.0 | Ag-1.0at%Mg | 10 | Balance | 30.0 | 0.1 | 0.0 |
| | 26* | Balance | 0.5 | 10.0 | 0.0 | Ag-1.0at%Cu | 10 | Balance | 0.5 | 10.0 | 0.0 |
| | 27* | Balance | 0.5 | 10.0 | 0.0 | Ag-1.0at%Sn | 10 | Balance | 0.5 | 10.0 | 0.0 |
| | 28* | Balance | 0.5 | 10.0 | 0.0 | Ag-1.0at%Sb | 10 | Balance | 0.5 | 10.0 | 0.0 |
| | 29* | Balance | 0.5 | 10.0 | 0.0 | Ag-1.0at%Ti | 10 | Balance | 0.5 | 10.0 | 0.0 |
| | 30* | Balance | 0.5 | 10.0 | 0.0 | Ag-1.0at%Mg | 10 | Balance | 0.5 | 10.0 | 0.0 |
| | 31 | Balance | 14.0 | 2.5 | 0.0 | Ag | 6 | Balance | 14.0 | 2.5 | 0.0 |
| | 32 | Balance | 14.0 | 2.5 | 0.0 | Ag | 10 | Balance | 14.0 | 2.5 | 0.0 |

* Reference Example

[Table 2]

| | | First Transparent Conductive Oxide Film | | | | Ag Film | | Second Transparent Conductive Oxide Film | | | |
|---|---|---|---|---|---|---|---|---|---|---|---|
| | | at% with respect to All Metal Components | | | | Composition | Thickness nm | at% with respect to All Metal Components | | | |
| | | Zn | Ga | Ti | Y | | | Zn | Ga | Ti | Y |
| Example | 33 | Balance | 14.0 | 2.5 | 4.0 | Ag-1.0at%Cu | 10 | Balance | 14.0 | 2.5 | 4.0 |
| | 34 | Balance | 14.0 | 2.5 | 4.0 | Ag-1.0at%Sn | 10 | Balance | 14.0 | 2.5 | 4.0 |
| | 35 | Balance | 14.0 | 2.5 | 4.0 | Ag-1.0at%Sb | 10 | Balance | 14.0 | 2.5 | 4.0 |
| | 36 | Balance | 14.0 | 2.5 | 4.0 | Ag-1.0at%Ti | 10 | Balance | 14.0 | 2.5 | 4.0 |
| | 37 | Balance | 14.0 | 2.5 | 4.0 | Ag-1.0at%Mg | 10 | Balance | 14.0 | 2.5 | 4.0 |
| | 38 | Balance | 30.0 | 0.1 | 0.1 | Ag-1.0at%Cu | 10 | Balance | 30.0 | 0.1 | 0.1 |
| | 39 | Balance | 30.0 | 0.1 | 0.1 | Ag-1.0at%Sn | 10 | Balance | 30.0 | 0.1 | 0.1 |
| | 40 | Balance | 30.0 | 0.1 | 0.1 | Ag-1.0at%Sb | 10 | Balance | 30.0 | 0.1 | 0.1 |
| | 41 | Balance | 30.0 | 0.1 | 0.1 | Ag-1.0at%Ti | 10 | Balance | 30.0 | 0.1 | 0.1 |
| | 42 | Balance | 30.0 | 0.1 | 0.1 | Ag-1.0at%Mg | 10 | Balance | 30.0 | 0.1 | 0.1 |
| | 43* | Balance | 0.5 | 10.0 | 10.0 | Ag-1.0at%Cu | 10 | Balance | 0.5 | 10.0 | 10.0 |
| | 44* | Balance | 0.5 | 10.0 | 10.0 | Ag-1.0at%Sn | 10 | Balance | 0.5 | 10.0 | 10.0 |
| | 45* | Balance | 0.5 | 10.0 | 10.0 | Ag-1.0at%Sb | 10 | Balance | 0.5 | 10.0 | 10.0 |
| | 46* | Balance | 0.5 | 10.0 | 10.0 | Ag-1.0at%Ti | 10 | Balance | 0.5 | 10.0 | 10.0 |
| | 47* | Balance | 0.5 | 10.0 | 10.0 | Ag-1.0at%Mg | 10 | Balance | 0.5 | 10.0 | 10.0 |
| | 48 | Balance | 14.0 | 2.5 | 4.0 | Ag | 6 | Balance | 14.0 | 2.5 | 4.0 |
| | 49 | Balance | 14.0 | 2.5 | 4.0 | Ag | 10 | Balance | 14.0 | 2.5 | 4.0 |
| | 50 | Balance | 14.0 | 2.5 | 4.0 | Ag-0.5at%Cu-0.5at%Sn | 10 | Balance | 14.0 | 2.5 | 4.0 |
| | 51 | Balance | 14.0 | 2.5 | 4.0 | Ag-5.0at%Cu-5.0at%Sn | 10 | Balance | 14.0 | 2.5 | 4.0 |
| | 52 | Balance | 14.0 | 2.5 | 4.0 | Ag-0.5at%Cu-0.5at%Sb | 10 | Balance | 14.0 | 2.5 | 4.0 |
| | 53 | Balance | 14.0 | 2.5 | 4.0 | Ag-0.5at%Cu-0.5at%Ti | 10 | Balance | 14.0 | 2.5 | 4.0 |
| | 54 | Balance | 14.0 | 2.5 | 4.0 | Ag-5.0at%Cu-5.0at%Mg | 10 | Balance | 14.0 | 2.5 | 4.0 |
| | 55 | Balance | 14.0 | 2.5 | 4.0 | Ag-0.5at%Sn-0.5at%Sb | 10 | Balance | 14.0 | 2.5 | 4.0 |

(continued)

| | | First Transparent Conductive Oxide Film | | | | Ag Film | | Second Transparent Conductive Oxide Film | | | |
|---|---|---|---|---|---|---|---|---|---|---|---|
| | | at% with respect to All Metal Components | | | | Composition | Thickness nm | at% with respect to All Metal Components | | | |
| | | Zn | Ga | Ti | Y | | | Zn | Ga | Ti | Y |
| | 56 | Balance | 14.0 | 2.5 | 4.0 | Ag-0.5at%Sn-0.5at%Ti | 10 | Balance | 14.0 | 2.5 | 4.0 |
| | 57 | Balance | 14.0 | 2.5 | 4.0 | Ag-0.5 at%Sb -0.5 at%Ti | 10 | Balance | 14.0 | 2.5 | 4.0 |
| | 58 | Balance | 14.0 | 2.5 | 4.0 | Ag-0.5at%Sb-0.5at%Mg | 10 | Balance | 14.0 | 2.5 | 4.0 |
| | 59 | Balance | 14.0 | 2.5 | 4.0 | Ag-1.0at%Cu | 10 | Balance | 14.0 | 2.5 | 0.0 |
| | 60 | Balance | 14.0 | 2.5 | 0.0 | Ag-1.0at%Cu | 10 | Balance | 14.0 | 2.5 | 4.0 |
| | 61 | Balance | 14.0 | 2.5 | 4.0 | Ag-1.0at%Sn | 10 | Balance | 14.0 | 2.5 | 0.0 |
| | 62 | Balance | 14.0 | 2.5 | 0.0 | Ag-1.0at%Sn | 10 | Balance | 14.0 | 2.5 | 4.0 |
| | 63 | Balance | 14.0 | 2.5 | 4.0 | Ag-1.0at%Sb | 10 | Balance | 14.0 | 2.5 | 0.0 |
| | 64 | Balance | 14.0 | 2.5 | 0.0 | Ag-1.0at%Sb | 10 | Balance | 14.0 | 2.5 | 4.0 |
| | 65 | Balance | 14.0 | 2.5 | 4.0 | Ag-1.0at%Ti | 10 | Balance | 14.0 | 2.5 | 0.0 |
| | 66 | Balance | 14.0 | 2.5 | 0.0 | Ag-1.0at%Ti | 10 | Balance | 14.0 | 2.5 | 4.0 |
| | 67 | Balance | 14.0 | 2.5 | 4.0 | Ag-1.0at%Mg | 10 | Balance | 14.0 | 2.5 | 0.0 |
| | 68 | Balance | 14.0 | 2.5 | 0.0 | Ag-1.0at%Mg | 10 | Balance | 14.0 | 2.5 | 4.0 |
| * Reference Example | | | | | | | | | | | |

[Table 3]

| | | First Transparent Conductive Oxide Film | | | | Ag Film | | Second Transparent Conductive Oxide Film | | | |
|---|---|---|---|---|---|---|---|---|---|---|---|
| | | at% with respect to All Metal Components | | | | Composition | Thickness nm | at% with respect to All Metal Components | | | |
| | | Zn | Ga | Ti | Y | | | Zn | Ga | Ti | Y |
| Example | 69 | Balance | 18.0 | 2.5 | 0.0 | Ag-1.0at%Cu | 10 | Balance | 18.0 | 2.5 | 0.0 |
| | 70 | Balance | 18.0 | 2.5 | 0.0 | Ag-1.0at%Sn | 10 | Balance | 18.0 | 2.5 | 0.0 |
| | 71 | Balance | 18.0 | 2.5 | 0.0 | Ag-1.0at%Sb | 10 | Balance | 18.0 | 2.5 | 0.0 |
| | 72 | Balance | 18.0 | 2.5 | 0.0 | Ag-1.0at%Ti | 10 | Balance | 18.0 | 2.5 | 0.0 |
| | 73 | Balance | 18.0 | 2.5 | 0.0 | Ag-1.0at%Mg | 10 | Balance | 18.0 | 2.5 | 0.0 |
| | 74 | Balance | 18.0 | 2.5 | 4.0 | Ag-1.0at%Cu | 10 | Balance | 18.0 | 2.5 | 4.0 |
| | 75 | Balance | 18.0 | 2.5 | 4.0 | Ag-1.0at%Sn | 10 | Balance | 18.0 | 2.5 | 4.0 |
| | 76 | Balance | 18.0 | 2.5 | 4.0 | Ag-1.0at%Sb | 10 | Balance | 18.0 | 2.5 | 4.0 |
| | 77 | Balance | 18.0 | 2.5 | 4.0 | Ag-1.0at%Ti | 10 | Balance | 18.0 | 2.5 | 4.0 |
| | 78 | Balance | 18.0 | 2.5 | 4.0 | Ag-1.0at%Mg | 10 | Balance | 18.0 | 2.5 | 4.0 |
| | 79 | Balance | 20.0 | 2.5 | 4.0 | Ag-1.0at%Cu | 10 | Balance | 20.0 | 2.5 | 4.0 |
| | 80 | Balance | 20.0 | 2.5 | 4.0 | Ag-1.0at%Sn | 10 | Balance | 20.0 | 2.5 | 4.0 |
| | 81 | Balance | 20.0 | 2.5 | 4.0 | Ag-1.0at%Sb | 10 | Balance | 20.0 | 2.5 | 4.0 |
| | 82 | Balance | 20.0 | 2.5 | 4.0 | Ag-1.0at%Ti | 10 | Balance | 20.0 | 2.5 | 4.0 |
| | 83 | Balance | 20.0 | 2.5 | 4.0 | Ag-1.0at%Mg | 10 | Balance | 20.0 | 2.5 | 4.0 |
| | 84 | Balance | 14.0 | 2.5 | 4.0 | Ag-1.0at%Zn | 10 | Balance | 14.0 | 2.5 | 4.0 |
| | 85 | Balance | 14.0 | 2.5 | 4.0 | Ag-1.0at%Ge | 10 | Balance | 14.0 | 2.5 | 4.0 |
| | 86 | Balance | 14.0 | 2.5 | 4.0 | Ag-1.0at%In | 10 | Balance | 14.0 | 2.5 | 4.0 |
| | 87 | Balance | 14.0 | 2.5 | 4.0 | Ag-1.0at%Al | 10 | Balance | 14.0 | 2.5 | 4.0 |
| | 88 | Balance | 14.0 | 2.5 | 4.0 | Ag-1.0at%Ga | 10 | Balance | 14.0 | 2.5 | 4.0 |
| | 89 | Balance | 14.0 | 2.5 | 4.0 | Ag-1.0at%Pd | 10 | Balance | 14.0 | 2.5 | 4.0 |
| | 90 | Balance | 14.0 | 2.5 | 4.0 | Ag-1.0at%Au | 10 | Balance | 14.0 | 2.5 | 4.0 |
| | 91 | Balance | 14.0 | 2.5 | 4.0 | Ag-1.0at%Pt | 10 | Balance | 14.0 | 2.5 | 4.0 |
| | 92 | Balance | 14.0 | 2.5 | 4.0 | Ag-1.0at%Bi | 10 | Balance | 14.0 | 2.5 | 4.0 |
| | 93 | Balance | 14.0 | 2.5 | 4.0 | Ag-1.0at%Mn | 10 | Balance | 14.0 | 2.5 | 4.0 |
| | 94 | Balance | 14.0 | 2.5 | 4.0 | Ag-1.0at%Sc | 10 | Balance | 14.0 | 2.5 | 4.0 |
| | 95 | Balance | 14.0 | 2.5 | 4.0 | Ag-1.0at%Y | 10 | Balance | 14.0 | 2.5 | 4.0 |
| | 96 | Balance | 14.0 | 2.5 | 4.0 | Ag-1.0at%Nd | 10 | Balance | 14.0 | 2.5 | 4.0 |
| | 97 | Balance | 14.0 | 2.5 | 4.0 | Ag-1.0at%Sm | 10 | Balance | 14.0 | 2.5 | 4.0 |
| | 98 | Balance | 14.0 | 2.5 | 4.0 | Ag-1.0at%Eu | 10 | Balance | 14.0 | 2.5 | 4.0 |
| | 99 | Balance | 14.0 | 2.5 | 4.0 | Ag-1.0at%Gd | 10 | Balance | 14.0 | 2.5 | 4.0 |
| | 100 | Balance | 14.0 | 2.5 | 4.0 | Ag-1.0at%Tb | 10 | Balance | 14.0 | 2.5 | 4.0 |
| | 101 | Balance | 14.0 | 2.5 | 4.0 | Ag-1.0at%Er | 10 | Balance | 14.0 | 2.5 | 4.0 |

[Table 4]

| | | First Transparent Conductive Oxide Film | | Ag Film | | Second Transparent Conductive Oxide Film | |
|---|---|---|---|---|---|---|---|
| | | Composition | Thickness nm | Composition | Thickness nm | Composition | Thickness nm |
| Comparative Example | 1 | ITO | 40 | Ag-1.0at%Cu | 5 | ITO | 40 |
| | 2 | ITO | 40 | Ag-1.0at%Cu | 10 | ITO | 40 |
| | 3 | ITO | 40 | Ag-1.0at%Sn | 5 | ITO | 40 |
| | 4 | ITO | 40 | Ag-1.0at%Sn | 10 | ITO | 40 |
| | 5 | ITO | 40 | Ag-1.0at%Sb | 5 | ITO | 40 |
| | 6 | ITO | 40 | Ag-1.0at%Sb | 10 | ITO | 40 |
| | 7 | ITO | 40 | Ag-1.0at%Ti | 5 | ITO | 40 |
| | 8 | ITO | 40 | Ag-1.0at%Ti | 10 | ITO | 40 |
| | 9 | ITO | 40 | Ag-1.0at%Mg | 5 | ITO | 40 |
| | 10 | ITO | 40 | Ag-1.0at%Mg | 10 | ITO | 40 |
| | 11 | ITO | 40 | Ag | 5 | ITO | 40 |
| | 12 | ITO | 40 | Ag | 10 | ITO | 40 |
| | 13 | GZO | 40 | Ag-1.0at%Cu | 5 | GZO | 40 |
| | 14 | GZO | 40 | Ag-1.0at%Cu | 10 | GZO | 40 |
| | 15 | GZO | 40 | Ag-1.0at%Sn | 5 | GZO | 40 |
| | 16 | GZO | 40 | Ag-1.0at%Sn | 10 | GZO | 40 |
| | 17 | GZO | 40 | Ag-1.0at%Sb | 5 | GZO | 40 |
| | 18 | GZO | 40 | Ag-1.0at%Sb | 10 | GZO | 40 |
| | 19 | GZO | 40 | Ag-1.0at%Ti | 5 | GZO | 40 |
| | 20 | GZO | 40 | Ag-1.0at%Ti | 10 | GZO | 40 |
| | 21 | GZO | 40 | Ag-1.0at%Mg | 5 | GZO | 40 |
| | 22 | GZO | 40 | Ag-1.0at%Mg | 10 | GZO | 40 |
| | 23 | GZO | 40 | Ag | 5 | GZO | 40 |
| | 24 | GZO | 40 | Ag | 10 | GZO | 40 |

(continued)

| | | First Transparent Conductive Oxide Film | | Ag Film | | Second Transparent Conductive Oxide Film | |
|---|---|---|---|---|---|---|---|
| | | Composition | Thickness nm | Composition | Thickness nm | Composition | Thickness nm |
| | A | ITO | 600 | - | - | - | - |
| | B | ITO | 180 | - | - | - | - |

[Table 5]

| | | Sheet Resistance | | | | | Length of Over-Etching (μm) |
|---|---|---|---|---|---|---|---|
| | | Before Test | After Temperature-And-Humidity-Controlled Test | | After Alkali Resistance Test | | |
| | | (Ω/sq.) | (Ω/sq.) | Change Rate (%) | (Ω/Sq.) | Change Rate (%) | |
| Example | 1 | 4.1 | 4.0 | -2.4 | 4.2 | 2.4 | 0.5 |
| | 2 | 8.9 | 8.6 | -3.4 | 9.1 | 2.2 | 0.4 |
| | 3 | 3.9 | 3.8 | -2.6 | 4.0 | 2.6 | 0.4 |
| | 4 | 12.1 | 11.7 | -3.3 | 12.5 | 3.3 | 0.7 |
| | 5 | 4.4 | 4.2 | -4.5 | 4.5 | 2.3 | 0.6 |
| | 6 | 9.1 | 8.9 | -2.2 | 9.4 | 3.3 | 0.5 |
| | 7 | 4.1 | 4.0 | -2.4 | 4.2 | 2.4 | 0.4 |
| | 8 | 10.8 | 10.4 | -3.7 | 11.2 | 3.7 | 0.8 |
| | 9 | 4.0 | 3.9 | -2.5 | 4.1 | 2.5 | 0.5 |
| | 10 | 8.8 | 8.6 | -2.3 | 9.1 | 3.4 | 0.6 |
| | 11 | 3.8 | 3.7 | -2.6 | 3.9 | 2.6 | 0.4 |
| | 12 | 11.8 | 11.5 | -2.5 | 12.1 | 2.5 | 0.6 |
| | 13 | 4.6 | 4.5 | -2.2 | 4.7 | 2.2 | 0.5 |
| | 14 | 9.3 | 9.0 | -3.2 | 9.6 | 3.2 | 0.8 |
| | 15 | 4.3 | 4.2 | -2.3 | 4.4 | 2.3 | 0.5 |
| | 16 | 13.0 | 12.6 | -3.1 | 13.4 | 3.1 | 0.7 |
| | 17 | 4.2 | 4.1 | -2.4 | 4.3 | 2.4 | 0.4 |
| | 18 | 9.0 | 8.7 | -3.3 | 9.2 | 2.2 | 0.7 |
| | 19 | 3.9 | 3.8 | -2.6 | 4.0 | 2.6 | 0.5 |
| | 20 | 12.2 | 11.8 | -3.3 | 12.6 | 3.3 | 0.6 |
| | 21 | 4.1 | 4.0 | -2.4 | 4.2 | 2.4 | 0.5 |
| | 22 | 4.2 | 4.1 | -2.4 | 4.3 | 2.4 | 0.6 |
| | 23 | 3.9 | 3.8 | -2.6 | 4.0 | 2.6 | 0.3 |
| | 24 | 4.4 | 4.3 | -2.3 | 4.5 | 2.3 | 0.6 |
| | 25 | 4.0 | 3.9 | -2.5 | 4.1 | 2.5 | 0.4 |
| | 26* | 4.3 | 4.2 | -2.3 | 4.4 | 2.3 | 0.5 |
| | 27* | 4.4 | 4.3 | -2.3 | 4.5 | 2.3 | 0.5 |
| | 28* | 4.1 | 4.0 | -2.4 | 4.2 | 2.4 | 0.6 |
| | 29* | 4.6 | 4.5 | -2.2 | 4.7 | 2.2 | 0.5 |
| | 30* | 4.2 | 4.1 | -2.4 | 4.3 | 2.4 | 0.6 |
| | 31 | 17.6 | 19.6 | 11.4 | 19.8 | 12.5 | 0.8 |
| | 32 | 5.2 | 5.7 | 9.6 | 5.8 | 11.5 | 0.7 |

* Reference Example

[Table 6]

| | Sheet Resistance | | | | | Length of Over-Etching (μm) |
|---|---|---|---|---|---|---|
| | Before Test | After Temperature-And-Humidity-Controlled Test | | After Alkali Resistance Test | | |
| | (Ω/sq.) | (Ω/sq.) | Change Rate (%) | (Ω/Sq.) | Change Rate (%) | |

(continued)

| | | Sheet Resistance | | | | | Length of Over-Etching (μm) |
|---|---|---|---|---|---|---|---|
| | | Before Test | After Temperature-And-Humidity-Controlled Test | | After Alkali Resistance Test | | |
| | | (Ω/sq.) | (Ω/sq.) | Change Rate (%) | (Ω/Sq.) | Change Rate (%) | |
| Example | 33 | 4.1 | 4.0 | -2.4 | 4.2 | 2.4 | 0.5 |
| | 34 | 4.3 | 4.2 | -2.3 | 4.4 | 2.3 | 0.5 |
| | 35 | 4.0 | 3.9 | -2.5 | 4.1 | 2.5 | 0.6 |
| | 36 | 4.5 | 4.4 | -2.2 | 4.6 | 2.2 | 0.4 |
| | 37 | 4.6 | 4.5 | -2.2 | 4.7 | 2.2 | 0.6 |
| | 38 | 4.2 | 4.1 | -2.4 | 4.3 | 2.4 | 0.5 |
| | 39 | 4.3 | 4.2 | -2.3 | 4.4 | 2.3 | 0.6 |
| | 40 | 4.1 | 4.0 | -2.4 | 4.2 | 2.4 | 0.5 |
| | 41 | 4.5 | 4.4 | -2.2 | 4.6 | 2.2 | 0.6 |
| | 42 | 4.1 | 4.0 | -2.4 | 4.2 | 2.4 | 0.5 |
| | 43* | 4.5 | 4.4 | -2.2 | 4.6 | 2.2 | 0.5 |
| | 44* | 4.6 | 4.5 | -2.2 | 4.7 | 2.2 | 0.7 |
| | 45* | 4.3 | 4.2 | -2.3 | 4.4 | 2.3 | 0.5 |
| | 46* | 4.7 | 4.6 | -2.1 | 4.8 | 2.1 | 0.6 |
| | 47* | 4.4 | 4.3 | -2.3 | 4.5 | 2.3 | 0.5 |
| | 48 | 18.2 | 19.8 | 8.8 | 19.0 | 4.4 | 0.9 |
| | 49 | 5.6 | 6.0 | 7.1 | 5.9 | 5.4 | 0.7 |
| | 50 | 4.0 | 3.9 | -2.5 | 4.1 | 2.5 | 0.5 |
| | 51 | 6.2 | 6.0 | -3.2 | 6.5 | 4.8 | 0.7 |
| | 52 | 3.9 | 3.8 | -2.6 | 4.0 | 2.6 | 0.6 |
| | 53 | 4.1 | 4.0 | -2.4 | 4.2 | 2.4 | 0.5 |
| | 54 | 6.4 | 6.2 | -3.1 | 6.6 | 3.1 | 0.7 |
| | 55 | 3.9 | 3.8 | -2.6 | 4.0 | 2.6 | 0.4 |
| | 56 | 4.2 | 4.1 | -2.4 | 4.3 | 2.4 | 0.6 |
| | 57 | 4.1 | 4.0 | -2.4 | 4.2 | 2.4 | 0.5 |
| | 58 | 4.0 | 3.9 | -2.5 | 4.1 | 2.5 | 0.4 |
| | 59 | 3.9 | 3.8 | -2.6 | 4.0 | 2.6 | 0.5 |
| | 60 | 4.1 | 4.0 | -2.4 | 4.2 | 2.4 | 0.6 |
| | 61 | 4.1 | 4.0 | -2.4 | 4.2 | 2.4 | 0.6 |
| | 62 | 4.3 | 4.2 | -2.3 | 4.4 | 2.3 | 0.5 |
| | 63 | 3.8 | 3.7 | -2.6 | 3.9 | 2.6 | 0.4 |
| | 64 | 4.0 | 3.9 | -2.5 | 4.1 | 2.5 | 0.6 |
| | 65 | 4.3 | 4.2 | -2.3 | 4.4 | 2.3 | 0.5 |
| | 66 | 4.5 | 4.4 | -2.2 | 4.6 | 2.2 | 0.6 |
| | 67 | 3.9 | 3.8 | -2.6 | 4.0 | 2.6 | 0.5 |
| | 68 | 4.1 | 4.0 | -2.4 | 4.2 | 2.4 | 0.6 |
| * Reference Example | | | | | | | |

[Table 7]

| | | Sheet Resistance | | | | | Length of Over-Etching (μm) |
| | | Before Test | After Temperature-And-Humidity-Controlled Test | | After Alkali Resistance Test | | |
| | | (Ω/sq.) | (Ω/sq.) | Change Rate (%) | (Ω/Sq.) | Change Rate (%) | |
|---|---|---|---|---|---|---|---|
| | 69 | 4.8 | 4.7 | -2.1 | 4.9 | 2.1 | 0.5 |
| | 70 | 4.9 | 4.8 | -2.0 | 5.0 | 2.0 | 0.5 |
| | 71 | 4.5 | 4.4 | -2.2 | 4.6 | 2.2 | 0.6 |
| | 72 | 5.0 | 4.9 | -2.0 | 5.1 | 2.0 | 0.4 |
| | 73 | 5.1 | 5.0 | -2.0 | 5.2 | 2.0 | 0.5 |
| | 74 | 4.9 | 4.8 | -2.0 | 5.0 | 2.0 | 0.5 |
| | 75 | 5.0 | 4.9 | -2.0 | 5.1 | 2.0 | 0.5 |
| | 76 | 4.7 | 4.6 | -2.1 | 4.8 | 2.1 | 0.6 |
| | 77 | 5.0 | 4.9 | -2.0 | 5.1 | 2.0 | 0.4 |
| | 78 | 5.2 | 5.1 | -1.9 | 5.3 | 1.9 | 0.6 |
| | 79 | 5.8 | 5.6 | -3.4 | 6.0 | 3.4 | 0.6 |
| | 80 | 5.9 | 5.7 | -3.4 | 6.1 | 3.4 | 0.6 |
| | 81 | 5.7 | 5.5 | -3.5 | 5.9 | 3.5 | 0.7 |
| | 82 | 6.2 | 6.0 | -3.2 | 6.4 | 3.2 | 0.5 |
| | 83 | 6.1 | 5.9 | -3.3 | 6.3 | 3.3 | 0.7 |
| | 84 | 4.3 | 4.2 | -2.3 | 4.4 | 2.3 | 0.5 |
| Example | 85 | 4.5 | 4.4 | -2.2 | 4.7 | 4.4 | 0.6 |
| | 86 | 4.3 | 4.2 | -2.3 | 4.4 | 2.3 | 0.6 |
| | 87 | 4.6 | 4.5 | -2.2 | 4.8 | 4.3 | 0.7 |
| | 88 | 4.5 | 4.4 | -2.2 | 4.7 | 4.4 | 0.6 |
| | 89 | 4.1 | 4.1 | 0.0 | 4.1 | 0.0 | 0.4 |
| | 90 | 4.0 | 4.0 | 0.0 | 4.0 | 0.0 | 0.4 |
| | 91 | 4.0 | 4.0 | 0.0 | 4.1 | 2.5 | 0.4 |
| | 92 | 3.9 | 3.8 | -2.6 | 4.0 | 2.6 | 0.6 |
| | 93 | 4.6 | 4.7 | 2.2 | 4.8 | 4.3 | 0.7 |
| | 94 | 4.6 | 4.8 | 4.3 | 4.8 | 4.3 | 0.8 |
| | 95 | 4.5 | 4.6 | 2.2 | 4.7 | 4.4 | 0.7 |
| | 96 | 4.7 | 4.6 | -2.1 | 4.9 | 4.3 | 0.6 |
| | 97 | 4.4 | 4.3 | -2.3 | 4.5 | 2.3 | 0.6 |
| | 98 | 4.3 | 4.2 | -2.3 | 4.4 | 2.3 | 0.5 |
| | 99 | 4.7 | 4.8 | 2.1 | 4.9 | 4.3 | 0.7 |
| | 100 | 4.8 | 5.0 | 4.2 | 5.0 | 4.2 | 0.9 |
| | 101 | 4.8 | 4.9 | 2.1 | 5.0 | 4.2 | 0.8 |

[Table 8]

| | | Sheet Resistance | | | | | Length of Over-Etching (μm) |
|---|---|---|---|---|---|---|---|
| | | Before Test | After Temperature-And-Humidity-Controlled Test | | After Alkali Resistance Test | | |
| | | (Ω/sq.) | (Ω/sq.) | Change Rate (%) | (Ω/Sq.) | Change Rate (%) | |
| Comparative Example | 1 | 15.3 | 17.4 | 13.7 | 15.4 | 0.7 | 4.2 |
| | 2 | 8.3 | 9.8 | 18.1 | 8.4 | 1.2 | 4.8 |
| | 3 | 14.9 | 16.8 | 12.8 | 15.0 | 0.7 | 4.6 |
| | 4 | 8.8 | 10.1 | 14.8 | 8.9 | 1.1 | 4.7 |
| | 5 | 13.6 | 18.4 | 35.3 | 13.8 | 1.5 | 3.9 |
| | 6 | 8.1 | 10.8 | 33.3 | 8.3 | 2.5 | 4.5 |
| | 7 | 15.5 | 17.4 | 12.3 | 15.7 | 1.3 | 4.9 |
| | 8 | 8.6 | 9.7 | 12.8 | 8.8 | 2.3 | 5.1 |
| | 9 | 15.3 | 17.2 | 12.4 | 15.4 | 0.7 | 4.8 |
| | 10 | 8.8 | 9.9 | 12.5 | 9.0 | 2.3 | 3.9 |
| | 11 | 18.9 | 25.6 | 35.4 | 20.3 | 7.4 | 5.4 |
| | 12 | 10.5 | 14.5 | 38.1 | 11.4 | 8.6 | 5.8 |
| | 13 | 10.5 | 11.9 | 13.3 | 11.9 | 13.3 | 2.9 |
| | 14 | 5.8 | 6.8 | 17.2 | 6.5 | 12.1 | 2.6 |
| | 15 | 11.2 | 12.5 | 11.6 | 12.5 | 11.6 | 3.1 |
| | 16 | 6.4 | 7.1 | 10.9 | 7.1 | 10.9 | 2.8 |
| | 17 | 10.2 | 12.0 | 17.6 | 12.3 | 20.6 | 2.8 |
| | 18 | 5.4 | 6.4 | 18.5 | 6.4 | 18.5 | 2.4 |
| | 19 | 11.5 | 13.2 | 14.8 | 12.8 | 11.3 | 3.0 |
| | 20 | 6.8 | 7.9 | 16.2 | 7.8 | 14.7 | 3.1 |
| | 21 | 11.3 | 13.0 | 15.0 | 12.6 | 11.5 | 2.9 |
| | 22 | 6.6 | 7.8 | 18.2 | 7.5 | 13.6 | 2.8 |
| | 23 | 8.8 | 11.4 | 29.5 | 11.0 | 25.0 | 3.9 |
| | 24 | 14.6 | 18.6 | 27.4 | 17.6 | 20.5 | 3.6 |
| | A | 9.8 | 9.4 | -4.1 | 9.7 | -1.0 | - |
| | B | 9.7 | 9.5 | -2.1 | 9.6 | -1.0 | - |

[Table 9]

| | | Transmittance | | | | |
|---|---|---|---|---|---|---|
| | | Before Test | After Temperature-And-Humidity-Controlled Test | | After Alkali Resistance Test | |
| | | (%) | (%) | Change Rate (%) | (%) | Change Rate (%) |
| Example | 1 | 85.6 | 86.0 | 0.5 | 85.7 | 0.1 |
| | 2 | 86.3 | 86.7 | 0.5 | 86.3 | 0.0 |
| | 3 | 85.9 | 86.2 | 0.3 | 86.0 | 0.1 |
| | 4 | 85.6 | 86.1 | 0.6 | 85.5 | -0.1 |
| | 5 | 85.5 | 86.0 | 0.6 | 85.6 | 0.1 |
| | 6 | 86.0 | 86.4 | 0.5 | 86.1 | 0.1 |
| | 7 | 85.7 | 86.1 | 0.5 | 85.8 | 0.1 |
| | 8 | 85.5 | 86.0 | 0.6 | 85.4 | -0.1 |
| | 9 | 85.7 | 86.2 | 0.6 | 85.6 | -0.1 |
| | 10 | 86.4 | 86.8 | 0.5 | 86.5 | 0.1 |
| | 11 | 86.2 | 86.6 | 0.5 | 86.1 | -0.1 |
| | 12 | 85.7 | 86.0 | 0.4 | 85.6 | -0.1 |
| | 13 | 85.4 | 85.8 | 0.5 | 85.3 | -0.1 |
| | 14 | 85.9 | 86.3 | 0.5 | 85.8 | -0.1 |
| | 15 | 85.7 | 86.0 | 0.4 | 85.7 | 0.0 |
| | 16 | 85.3 | 85.5 | 0.2 | 85.4 | 0.1 |
| | 17 | 85.6 | 86.0 | 0.5 | 85.5 | -0.1 |
| | 18 | 86.1 | 86.5 | 0.5 | 86.2 | 0.1 |
| | 19 | 85.8 | 86.2 | 0.5 | 85.7 | -0.1 |
| | 20 | 85.6 | 85.9 | 0.4 | 85.6 | 0.0 |
| | 21 | 86.0 | 86.3 | 0.3 | 85.8 | -0.2 |
| | 22 | 85.8 | 86.2 | 0.5 | 85.7 | -0.1 |
| | 23 | 86.3 | 86.6 | 0.3 | 86.1 | -0.2 |
| | 24 | 85.7 | 86.1 | 0.5 | 85.5 | -0.2 |
| | 25 | 85.8 | 86.2 | 0.5 | 85.6 | -0.2 |
| | 26* | 85.9 | 86.2 | 0.3 | 85.8 | -0.1 |
| | 27* | 85.7 | 86.0 | 0.4 | 85.6 | -0.1 |
| | 28* | 86.2 | 86.5 | 0.3 | 86.2 | 0.0 |
| | 29* | 85.7 | 86.1 | 0.5 | 85.7 | 0.0 |
| | 30* | 85.7 | 86.0 | 0.4 | 85.8 | 0.1 |
| | 31 | 85.1 | 85.5 | 0.5 | 85.2 | 0.1 |
| | 32 | 85.4 | 85.8 | 0.5 | 85.6 | 0.2 |

* Reference Example

[Table 10]

| | | Transmittance | | | | |
|---|---|---|---|---|---|---|
| | | Before Test | After Temperature-And-Humidity-Controlled Test | | After Alkali Resistance Test | |
| | | (%) | (%) | Change Rate (%) | (%) | Change Rate (%) |
| Example | 33 | 86.0 | 86.3 | 0.3 | 86.1 | 0.1 |
| | 34 | 85.8 | 86.1 | 0.3 | 85.8 | 0.0 |
| | 35 | 86.3 | 86.7 | 0.5 | 86.2 | -0.1 |
| | 36 | 85.8 | 86.0 | 0.2 | 85.8 | 0.0 |
| | 37 | 85.7 | 86.0 | 0.4 | 85.8 | 0.1 |
| | 38 | 86.1 | 86.4 | 0.3 | 86.0 | -0.1 |
| | 39 | 85.9 | 86.3 | 0.5 | 85.8 | -0.1 |
| | 40 | 86.4 | 86.7 | 0.3 | 86.5 | 0.1 |
| | 41 | 85.8 | 86.2 | 0.5 | 85.7 | -0.1 |
| | 42 | 85.7 | 86.1 | 0.5 | 85.8 | 0.1 |
| | 43* | 85.9 | 86.2 | 0.3 | 85.9 | 0.0 |
| | 44* | 85.8 | 86.0 | 0.2 | 85.7 | -0.1 |
| | 45* | 86.0 | 86.2 | 0.2 | 86.1 | 0.1 |
| | 46* | 85.6 | 85.8 | 0.2 | 85.6 | 0.0 |
| | 47* | 85.6 | 85.9 | 0.4 | 85.7 | 0.1 |
| | 48 | 85.3 | 85.5 | 0.2 | 85.4 | 0.1 |
| | 49 | 85.5 | 85.8 | 0.4 | 85.7 | 0.2 |
| | 50 | 85.9 | 86.2 | 0.3 | 86.0 | 0.1 |
| | 51 | 85.5 | 86.0 | 0.6 | 85.4 | -0.1 |
| | 52 | 86.2 | 86.5 | 0.3 | 86.2 | 0.0 |
| | 53 | 85.9 | 86.2 | 0.3 | 86.0 | 0.1 |
| | 54 | 85.6 | 86.0 | 0.5 | 85.5 | -0.1 |
| | 55 | 86.2 | 86.5 | 0.3 | 86.1 | -0.1 |
| | 56 | 85.8 | 86.1 | 0.3 | 85.9 | 0.1 |
| | 57 | 86.0 | 86.5 | 0.6 | 86.1 | 0.1 |
| | 58 | 86.0 | 86.3 | 0.3 | 85.9 | -0.1 |
| | 59 | 85.9 | 86.3 | 0.5 | 86.0 | 0.1 |
| | 60 | 86.0 | 86.4 | 0.5 | 85.9 | -0.1 |
| | 61 | 85.7 | 86.0 | 0.4 | 85.6 | -0.1 |
| | 62 | 85.8 | 86.1 | 0.3 | 85.9 | 0.1 |
| | 63 | 86.2 | 86.5 | 0.3 | 86.3 | 0.1 |
| | 64 | 86.3 | 86.6 | 0.3 | 86.2 | -0.1 |
| | 65 | 85.7 | 86.1 | 0.5 | 85.6 | -0.1 |
| | 66 | 85.8 | 86.1 | 0.3 | 85.8 | 0.0 |
| | 67 | 85.8 | 86.1 | 0.3 | 85.9 | 0.1 |

(continued)

| | | Transmittance | | | | |
|---|---|---|---|---|---|---|
| | | Before Test | After Temperature-And-Humidity-Controlled Test | | After Alkali Resistance Test | |
| | | (%) | (%) | Change Rate (%) | (%) | Change Rate (%) |
| | 68 | 85.7 | 86.1 | 0.5 | 85.6 | -0.1 |
| * Reference Example | | | | | | |

[Table 11]

| | | | Transmittance | | | |
|---|---|---|---|---|---|---|
| | | Before Test (%) | After Temperature-And-Humidity-Controlled Test | | After Alkali Resistance Test | |
| | | | (%) | Change Rate (%) | (%) | Change Rate (%) |
| Example | 69 | 85.6 | 86.0 | 0.5 | 85.5 | -0.1 |
| | 70 | 85.4 | 85.7 | 0.4 | 85.5 | 0.1 |
| | 71 | 85.9 | 86.4 | 0.6 | 85.8 | -0.1 |
| | 72 | 85.3 | 85.7 | 0.5 | 85.4 | 0.1 |
| | 73 | 85.4 | 85.9 | 0.6 | 85.3 | -0.1 |
| | 74 | 85.7 | 86.1 | 0.5 | 85.7 | 0.0 |
| | 75 | 85.4 | 85.7 | 0.4 | 85.5 | 0.1 |
| | 76 | 85.9 | 86.3 | 0.5 | 85.8 | -0.1 |
| | 77 | 85.4 | 85.8 | 0.5 | 85.4 | 0.0 |
| | 78 | 85.3 | 85.6 | 0.4 | 85.2 | -0.1 |
| | 79 | 85.4 | 85.8 | 0.5 | 85.2 | -0.2 |
| | 80 | 85.2 | 85.6 | 0.5 | 85.0 | -0.2 |
| | 81 | 85.6 | 85.9 | 0.4 | 85.4 | -0.2 |
| | 82 | 85.2 | 85.6 | 0.5 | 85.0 | -0.2 |
| | 83 | 85.0 | 85.3 | 0.4 | 84.8 | -0.2 |
| | 84 | 85.9 | 86.2 | 0.3 | 85.8 | -0.1 |
| | 85 | 85.7 | 86.1 | 0.5 | 85.5 | -0.2 |
| | 86 | 85.8 | 86.2 | 0.5 | 85.7 | -0.1 |
| | 87 | 85.6 | 85.9 | 0.4 | 85.4 | -0.2 |
| | 88 | 85.7 | 86.0 | 0.4 | 85.5 | -0.2 |
| | 89 | 86.1 | 86.4 | 0.3 | 86.2 | 0.1 |
| | 90 | 86.2 | 86.5 | 0.3 | 86.2 | 0.0 |
| | 91 | 86.2 | 86.6 | 0.5 | 86.2 | 0.0 |
| | 92 | 86.3 | 86.7 | 0.5 | 86.2 | -0.1 |
| | 93 | 85.5 | 85.8 | 0.4 | 85.3 | -0.2 |
| | 94 | 85.4 | 85.7 | 0.4 | 85.2 | -0.2 |
| | 95 | 85.5 | 85.8 | 0.4 | 85.2 | -0.4 |
| | 96 | 85.5 | 85.7 | 0.2 | 85.2 | -0.4 |
| | 97 | 85.6 | 85.9 | 0.4 | 85.4 | -0.2 |
| | 98 | 85.6 | 86.0 | 0.5 | 85.4 | -0.2 |
| | 99 | 85.4 | 85.6 | 0.2 | 85.1 | -0.4 |
| | 100 | 85.3 | 85.4 | 0.1 | 85.0 | -0.4 |
| | 101 | 85.4 | 85.6 | 0.2 | 85.1 | -0.4 |

[Table 12]

| | | Transmittance | | | | |
|---|---|---|---|---|---|---|
| | | Before Test (%) | After Temperature-And-Humidity-Controlled Test | | After Alkali Resistance Test | |
| | | | (%) | Change Rate (%) | (%) | Change Rate (%) |
| Comparative Example | 1 | 80.6 | 78.9 | -2.1 | 80.7 | 0.1 |
| | 2 | 80.4 | 79.2 | -1.5 | 80.5 | 0.1 |
| | 3 | 80.8 | 79.2 | -2.0 | 80.9 | 0.1 |
| | 4 | 80.6 | 79.6 | -1.2 | 80.5 | -0.1 |
| | 5 | 81.1 | 78.6 | -3.1 | 81.2 | 0.1 |
| | 6 | 80.7 | 79.0 | -2.1 | 80.8 | 0.1 |
| | 7 | 80.4 | 78.7 | -2.1 | 80.6 | 0.2 |
| | 8 | 80.2 | 79.0 | -1.5 | 80.3 | 0.1 |
| | 9 | 80.5 | 78.7 | -2.2 | 80.6 | 0.1 |
| | 10 | 80.3 | 79.2 | -1.4 | 80.4 | 0.1 |
| | 11 | 77.5 | 75.6 | -2.5 | 77.8 | 0.4 |
| | 12 | 79.8 | 78.1 | -2.1 | 80.2 | 0.5 |
| | 13 | 84.5 | 82.4 | -2.5 | 83.5 | -1.2 |
| | 14 | 84.2 | 82.3 | -2.3 | 83.4 | -1.0 |
| | 15 | 84.2 | 82.5 | -2.0 | 83.4 | -1.0 |
| | 16 | 84.0 | 82.5 | -1.8 | 83.3 | -0.8 |
| | 17 | 84.7 | 82.1 | -3.1 | 83.6 | -1.3 |
| | 18 | 84.5 | 82.2 | -2.7 | 83.6 | -1.1 |
| | 19 | 83.2 | 81.4 | -2.2 | 82.5 | -0.8 |
| | 20 | 83.1 | 81.3 | -2.2 | 82.0 | -1.3 |
| | 21 | 83.0 | 81.3 | -2.0 | 81.9 | -1.3 |
| | 22 | 83.2 | 81.6 | -1.9 | 82.2 | -1.2 |
| | 23 | 79.6 | 77.5 | -2.6 | 78.9 | -0.9 |
| | 24 | 80.0 | 78.1 | -2.4 | 79.1 | -1.1 |
| | A | 76.4 | 76.7 | 0.4 | 76.5 | 0.1 |
| | B | 84.1 | 84.3 | 0.2 | 84.2 | 0.1 |

In all the Examples, the average transmittance after film formation was higher than 85%, and the sheet resistance after film formation was 20 Ω/sq. or lower. Therefore, it was found that a multilayer transparent conductive film having high transmittance and sufficiently low resistance was obtained.

On the other hand, in all the Comparative Examples, the average transmittance after film formation was 85% or lower, and the sheet resistance after film formation was higher than that of Examples in a comparison between the samples having the same thickness of the Ag film. The reason for this is presumed to be that aggregation of the Ag film occurred in the Ag film.

In addition, in Comparative Example A, the sheet resistance was 10 Ω/sq. or lower by forming the ITO single layer film having a large thickness of 600 nm. However, the average transmittance was significantly decreased to 76.4%.

Further, in Comparative Example B, the thickness was 180 nm and the sheet resistance was 10 Ω/sq. or lower by heating the glass substrate to 200°C. However, the average transmittance was 85% or lower.

In addition, the results of the temperature-and-humidity-controlled test are as follows. In Examples, it was found that the change rates of the transmittance and the sheet resistance after the temperature-and-humidity-controlled test were small, and the environment resistance was high.

On the other hand, in Comparative Examples other than A and B, the change rate of the transmittance or the sheet resistance after the temperature-and-humidity-controlled test was large, and the environment resistance was insufficient.

In addition, the results of the alkali resistance test are as follows. In Examples, it was found that the change rates of the transmittance and the sheet resistance after the alkali resistance test were small, and the alkali resistance was high.

On the other hand, in the samples according to Comparative Examples 13 to 24, the change rates of the transmittance and the sheet resistance after the alkali resistance test were large, and the alkali resistance was insufficient.

In addition, the results of the patterning test using the etching method are as follows. In Examples, as shown in Tables 5, 6, and 7 and FIG. 7(a), the length of over-etching of the multilayer film was 1 μm or less, and thus it was found that a wiring pattern having no residues of the transparent conductive oxide film can be accurately formed.

On the other hand, in Comparative Examples, as shown in Table 8 and FIG. 7(b), the length of over-etching O of the multilayer film was more than 1 μm, the residues R of the transparent conductive oxide film were observed, and thus it was found that a wiring pattern cannot be accurately formed by collective etching.

In addition, the results of observing the surface of the multilayer film by visual inspection after the removal of the resist are as follows. In Examples, a change of the surface was not observed as compared to that before the test. On the other hand, in the multilayer films according to Comparative Examples 13 to 24 in which the GZO film not including Y and Ti was formed as the transparent conductive oxide film, film peeling was observed in places after the removal of the resist.

In addition, the results of the patterning test using the lift-off method are as follows. In Examples, it was found that a wiring pattern can be accurately formed.

On the other hand, in the multilayer films according to Comparative Examples 13 to 24 in which the GZO film not including Y and Ti was formed as the transparent conductive oxide film, film peeling was observed in places after the removal of the resist.

As described above, in Examples, it was found that aggregation of Ag does not occur even in a case where the Ag film is formed to be thin, and a multilayer transparent conductive film having a high transmittance and a low resistance value can be provided.

Industrial Applicability

In the multilayer transparent conductive film according to the present invention, transmittance is sufficiently high, electrical resistance is sufficiently low, environment resistance and alkali resistance are high, and over-etching is not likely to occur. Therefore, the multilayer transparent conductive film according to the present invention is suitable as a transparent electrode film of a display, a touch panel, or the like.

Reference Signs List

10: MULTILAYER TRANSPARENT CONDUCTIVE FILM
11: FIRST TRANSPARENT CONDUCTIVE OXIDE FILM (TRANSPARENT CONDUCTIVE OXIDE FILM)
12: Ag FILM
13: SECOND TRANSPARENT CONDUCTIVE OXIDE FILM (TRANSPARENT CONDUCTIVE OXIDE FILM)
20: SUBSTRATE
30: MULTILAYER WIRING FILM
41: RESIST FILM

Claims

1. A multilayer transparent conductive film (10), comprising:

an Ag film (12) that is formed of Ag or an Ag alloy, the Ag alloy optionally including 0.2 at% to 10.0 at% of one element or two or more elements in total selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er and a balance of Ag and inevitable impurities; and

a transparent conductive oxide film (11, 13) that is disposed on two opposite surfaces of the Ag film (12), wherein the transparent conductive oxide film (11, 13) is formed of an oxide including Zn, Ga, Ti, and optionally Y, **characterized in that** atomic proportions with respect to all the metal elements included in the transparent conductive oxide film (11, 13) are Ga: 1.0 at% to 30.0 at%, Ti: 0.1 at% to 10.0 at%, optionally Y: 0.1 at% to 10.0 at%, and a balance of Zn.

2. The multilayer transparent conductive film (10) according to Claim 1, wherein atomic proportions with respect to all the metal elements included in the transparent conductive oxide film (11, 13) are Ga: 1.0 at% to 18.0 at%, Ti: 0.1 at% to 10.0 at%, and a balance of Zn.

3. The multilayer transparent conductive film (10) according to Claim 2, wherein atomic proportions with respect to all the metal elements included in the transparent conductive oxide film (11, 13) are Ga: 1.0 at% to 14.0 at%, Ti: 0.1 at% to 10.0 at%, and a balance of Zn.

4. The multilayer transparent conductive film (10) according to Claim 1, wherein the oxide which forms the transparent conductive oxide film (11, 13) includes 0.1 at% to 10.0 at% of Y

5. The multilayer transparent conductive film (10) according to any one of Claims 1 to 4, wherein the Ag film (12) is formed of an Ag alloy including 0.2 at% to 10.0 at% of one element or two or more elements in total selected from the group consisting of Cu, Sn, Sb, Ti, Mg, Zn, Ge, In, Al, Ga, Pd, Au, Pt, Bi, Mn, Sc, Y, Nd, Sm, Eu, Gd, Tb, and Er and a balance of Ag and inevitable impurities.

6. The multilayer transparent conductive film (10) according to any one of Claims 1 to 5, wherein a thickness of the Ag film (12) is 10 nm or less.

7. The multilayer transparent conductive film (10) according to any one of Claims 1 to 6,

   wherein an average transmittance in a visible wavelength range of 400 to 800 nm is 85% or higher, and a sheet resistance value is 20 Ω/sq. or lower.

8. A multilayer wiring film (30) that is formed of the multilayer transparent conductive film (10) according to any one of Claims 1 to 7, the multilayer wiring film (30) comprising a wiring pattern.

9. A method of forming the multilayer wiring film (30) according to Claim 8, the method comprising:

   a multilayer transparent conductive film (10) forming step of forming the multilayer transparent conductive film (10) including the Ag film (12) and the transparent conductive oxide film (11, 13) on a film forming surface of a base material;
   a resist film forming step of forming a resist film (41) having a wiring pattern shape on the multilayer transparent conductive film (10);
   an etching step of collectively etching the multilayer transparent conductive film (10) on which the resist film (41) is formed by using an acidic mixed solution including phosphoric acid and acetic acid as an etchant; and
   a resist film removing step of removing the resist film (41) after etching.

10. A method of forming the multilayer wiring film (30) according to Claim 8, the method comprising:

    a resist film (41) forming step of forming a resist film (41) having a reverse pattern shape of the wiring pattern on a film forming surface of a base material;
    a multilayer transparent conductive film (10) forming step of forming the multilayer transparent conductive film (10) including the Ag film (12) and the transparent conductive oxide film (11, 13) on the film forming surface of the base material on which the resist film (41) is formed; and
    a resist film removing step of removing the resist film (41).

**Patentansprüche**

1. Mehrschichtiger transparenter leitfähiger Film (10), umfassend:

einen Ag-Film (12), der aus Ag oder einer Ag-Legierung gebildet ist, wobei die Ag-Legierung optional insgesamt 0,2 At-% bis 10,0 At-% von einem oder zwei oder mehreren Elementen, ausgewählt aus der Gruppe, bestehend aus Cu, Sn, Sb, Ti, Mg, Zn, Ge, In, Al, Ga, Pd, Au, Pt, Bi, Mn, Sc, Y, Nd, Sm, Eu, Gd, Tb und Er, und einen Rest aus Ag und unvermeidlichen Verunreinigungen einschließt, und

einen transparenten leitfähigen Oxidfilm (11, 13), der auf zwei entgegengesetzten Oberflächen des Ag-Films (12) angeordnet ist,

wobei der transparente leitfähige Oxidfilm (11, 13) aus einem Oxid gebildet ist, das Zn, Ga, Ti und optional Y einschließt,

**dadurch gekennzeichnet, dass** Atomanteile in Bezug auf alle Metallelemente, die in dem transparenten leitfähigen Oxidfilm (11, 13) eingeschlossen sind, Ga: 1,0 At-% bis 30,0 At-%, Ti: 0,1 At-% bis 10,0 At-%, optional Y: 0,1 At-% bis 10,0 At-% und ein Rest aus Zn sind.

2. Mehrschichtiger transparenter leitfähiger Film (10) gemäß Anspruch 1,
wobei Atomanteile in Bezug auf alle Metallelemente, die in dem transparenten leitfähigen Oxidfilm (11, 13) eingeschlossen sind, Ga: 1,0 At-% bis 18,0 At-%, Ti: 0,1 At-% bis 10,0 At-% und ein Rest aus Zn sind.

3. Mehrschichtiger transparenter leitfähiger Film (10) gemäß Anspruch 2,
wobei Atomanteile in Bezug auf alle Metallelemente, die in dem transparenten leitfähigen Oxidfilm (11, 13) eingeschlossen sind, Ga: 1,0 At-% bis 14,0 At-%, Ti: 0,1 At-% bis 10,0 At-% und ein Rest aus Zn sind.

4. Mehrschichtiger transparenter leitfähiger Film (10) gemäß Anspruch 1,
wobei das Oxid, das den transparenten leitfähigen Oxidfilm (11, 13) bildet, 0,1 At-% bis 10,0 At-% Y einschließt.

5. Mehrschichtiger transparenter leitfähiger Film (10) gemäß irgendeinem der Ansprüche 1 bis 4,
wobei der Ag-Film (12) aus einer Ag-Legierung gebildet ist, die insgesamt 0,2 At-% bis 10,0 At-% von einem oder zwei oder mehreren Elementen, ausgewählt aus der Gruppe, bestehend aus Cu, Sn, Sb, Ti, Mg, Zn, Ge, In, Al, Ga, Pd, Au, Pt, Bi, Mn, Sc, Y, Nd, Sm, Eu, Gd, Tb und Er, und einen Rest aus Ag und unvermeidlichen Verunreinigungen einschließt.

6. Mehrschichtiger transparenter leitfähiger Film (10) gemäß irgendeinem der Ansprüche 1 bis 5,
wobei eine Dicke des Ag-Films (12) 10 nm oder weniger beträgt.

7. Mehrschichtiger transparenter leitfähiger Film (10) gemäß irgendeinem der Ansprüche 1 bis 6,

wobei eine durchschnittliche Transmission in einem sichtbaren Wellenlängenbereich von 400 bis 800 nm 85 % oder höher ist und
ein Schichtwiderstandswert 20 $\Omega$/sq. oder niedriger ist.

8. Mehrschichtiger Verdrahtungsfilm (30), der aus dem mehrschichtigen transparenten leitfähigen Film (10) gemäß irgendeinem der Ansprüche 1 bis 7 gebildet ist, wobei der mehrschichtige Verdrahtungsfilm (30) ein Verdrahtungsmuster umfasst.

9. Verfahren zur Bildung des mehrschichtigen Verdrahtungsfilms (30) gemäß Anspruch 8, wobei das Verfahren umfasst:

einen Schritt zur Bildung eines mehrschichtigen transparenten leitfähigen Films (10), in dem der mehrschichtige transparente leitfähige Film (10), der den Ag-Film (12) und den transparenten leitfähigen Oxidfilm (11, 13) einschließt, auf einer Filmbildungsoberfläche eines Basismaterials gebildet wird,
einen Resistfilmbildungsschritt, in dem ein Resistfilm (41) mit einer Verdrahtungsmusterform auf dem mehrschichtigen transparenten leitfähigen Film (10) gebildet wird,
einen Ätzschritt, in dem der mehrschichtige transparente leitfähige Film (10), auf dem der Resistfilm (41) gebildet ist, gemeinsam unter Verwendung einer sauren Mischlösung, die Phosphorsäure und Essigsäure einschließt, als Ätzmittel geätzt wird, und
einen Resistfilm (41) nach dem Ätzen entfernt wird.

10. Verfahren zur Bildung des mehrschichtigen Verdrahtungsfilms (30) gemäß Anspruch 8, wobei das Verfahren umfasst:

einen Schritt zur Bildung eines Resistfilms (41), in dem ein Resistfilm (41) mit einer umgekehrten Musterform des Verdrahtungsmusters auf einer Filmbildungsoberfläche eines Basismaterials gebildet wird, einen Schritt zur Bildung eines mehrschichtigen leitfähigen Films (10), in dem der mehrschichtige transparente leitfähige Film (10), der den Ag-Film (12) und den transparenten leitfähigen Oxidfilm (11, 13) einschließt, auf der Filmbildungsoberfläche des Basismaterials, auf der der Resistfilm gebildet ist, gebildet wird, und einen Resistfilm-Entfernungsschritt, in dem der Resistfilm (41) entfernt wird.

**Revendications**

**1.** Film conducteur transparent stratifié (10), comprenant :

un film d'Ag (12) qui est constitué d'Ag ou d'un alliage d'Ag, l'alliage d'Ag incluant éventuellement de 0,2 at% à 10,0 at% d'un élément ou deux éléments ou plus au total sélectionnés dans le groupe constitué par Cu, Sn, Sb, Ti, Mg, Zn, Ge, In, Al, Ga, Pd, Au, Pt, Bi, Mn, Sc, Y, Nd, Sm, Eu, Gd, Tb et Er et un reste constitué d'Ag et des inévitables impuretés ; et
un film d'oxyde conducteur transparent (11, 13) qui est disposé sur deux surfaces opposées du film d'Ag (12), dans lequel le film d'oxyde conducteur transparent (11, 13) est constitué d'un oxyde incluant Zn, Ga, TI et éventuellement Y,
**caractérisé en ce que** des proportions atomiques par rapport à l'ensemble des éléments métalliques inclus dans le film d'oxyde conducteur transparent (11, 13) sont Ga : de 1,0 at% à 30,0 at%, Ti : de 0,1 at% à 10,0 at%, éventuellement Y : de 0,1 at% à 10,0 at%, et un reste constitué de Zn.

**2.** Film conducteur transparent stratifié (10) selon la revendication 1,
dans lequel des proportions atomiques par rapport à l'ensemble des éléments métalliques inclus dans le film d'oxyde conducteur transparent (11, 13) sont Ga : de 1,0 at% à 18,0 at%, Ti : de 0,1 at% à 10,0 at%, et un reste constitué de Zn.

**3.** Film conducteur transparent stratifié (10) selon la revendication 2,
dans lequel des proportions atomiques par rapport à l'ensemble des éléments métalliques inclus dans le film d'oxyde conducteur transparent (11, 13) sont Ga : de 1,0 at% à 14,0 at%, Ti : de 0,1 at% à 10,0 at%, et un reste constitué de Zn.

**4.** Film conducteur transparent stratifié (10) selon la revendication 1,
dans lequel l'oxyde qui forme le film d'oxyde conducteur transparent (11, 13) inclut de 0,1 at% à 10,0 at% de Y.

**5.** Film conducteur transparent stratifié (10) selon l'une quelconque des revendications 1 à 4,
dans lequel le film d'Ag (12) est constitué d'un alliage d'Ag incluant de 0,2 at% à 10,0 at% d'un élément ou deux éléments ou plus au total sélectionnés dans le groupe constitué par Cu, Sn, Sb, Ti, Mg, Zn, Ge, In, Al, Ga, Pd, Au, Pt, Bi, Mn, Sc, Y, Nd, Sm, Eu, Gd, Tb et Er et un reste constitué d'Ag et des inévitables impuretés.

**6.** Film conducteur transparent stratifié (10) selon l'une quelconque des revendications 1 à 5,
dans lequel une épaisseur du film d'Ag (12) est de 10 nm ou moins.

**7.** Film conducteur transparent stratifié (10) selon l'une quelconque des revendications 1 à 6,

dans lequel une transmittance moyenne dans une plage de longueurs d'onde visibles de 400 à 800 nm est de 85 % ou plus, et
une valeur de résistance surfacique est de 20 $\Omega$/carré ou moins.

**8.** Film de câblage stratifié (30) qui est constitué du film conducteur transparent stratifié (10) selon l'une quelconque des revendications 1 à 7, le film de câblage stratifié (30) comprenant un motif de câblage.

**9.** Procédé de formation du film de câblage stratifié (30) selon la revendication 8, le procédé comprenant :

une étape de formation d'un film conducteur transparent stratifié (10) consistant à former le film conducteur transparent stratifié (10) incluant le film d'Ag (12) et le film d'oxyde conducteur transparent (11, 13) sur une surface de formation de film d'un matériau de base ;
une étape de formation de film de réserve consistant à former un film de réserve (41) présentant une forme du motif de câblage sur le film conducteur transparent stratifié (10) ;

une étape de décapage consistant à décaper collectivement le film conducteur transparent stratifié (10) sur lequel le film de réserve (41) est formé en utilisant une solution mélangée acide incluant de l'acide phosphorique et de l'acide acétique à titre d'agent de décapage ; et
une étape de retrait du film de réserve consistant à retirer le film de réserve (41) après le décapage.

10. Procédé de formation du film de câblage stratifié (30) selon la revendication 8, le procédé comprenant :

une étape de formation d'un film de réserve (41) consistant à former un film de réserve (41) présentant une forme du motif inversé du motif de câblage sur une surface de formation de film d'un matériau de base ;
une étape de formation d'un film conducteur transparent stratifié (10) consistant à former le film conducteur transparent stratifié (10) incluant le film d'Ag (12) et le film d'oxyde conducteur transparent (11, 13) sur la surface de formation de film du matériau de base sur lequel le film de réserve (41) est formé ; et
une étape de retrait du film de réserve consistant à retirer le film de réserve (41).

FIG. 1

FIG. 2

FIG. 3

```
                                                    ⌒S11
┌─────────────────────────────────────┐
│      MULTILAYER TRANSPARENT          │
│   CONDUCTIVE FILM FORMING STEP       │
└─────────────────────────────────────┘
                  │
                  ▼                             ⌒S12
┌─────────────────────────────────────┐
│        RESIST FILM FORMING STEP      │
└─────────────────────────────────────┘
                  │
                  ▼                             ⌒S13
┌─────────────────────────────────────┐
│             ETCHING STEP             │
└─────────────────────────────────────┘
                  │
                  ▼                             ⌒S14
┌─────────────────────────────────────┐
│      RESIST FILM REMOVING STEP       │
└─────────────────────────────────────┘
                  │
                  ▼
        (   MULTILAYER WIRING FILM   )
```

FIG. 4

FIG. 5

```
                                          ┌─ S21
┌─────────────────────────────────────┐
│       RESIST FILM FORMING STEP        │
└─────────────────────────────────────┘
                    │
                    ▼                     ┌─ S22
┌─────────────────────────────────────┐
│         MULTILAYER TRANSPARENT        │
│     CONDUCTIVE FILM FORMING STEP      │
└─────────────────────────────────────┘
                    │
                    ▼                     ┌─ S23
┌─────────────────────────────────────┐
│       RESIST FILM REMOVING STEP       │
└─────────────────────────────────────┘
                    │
                    ▼
      (      MULTILAYER WIRING FILM      )
```

# FIG. 6

FIG. 7

(a)

LINE
(P)    SPACE
(S)

(b)

LINE        OVER-      RESIDUE
(P)   SPACE   ETCHING     (R)
(S)      (O)

FIG. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008310550 A
- JP 2006344163 A
- JP S63110507 A
- JP H09232278 A
- JP 2009298649 A